# EUROPEAN PATENT APPLICATION

(11) **EP 2 528 102 A1**
(43) Date of publication of application: **28.11.2012**
(21) Application number: 10843968.8
(22) Date of filing: 16.12.2010
(51) Int. Cl.: H01L 31/04

(54) **LIGHT TRANSMISSIVE SOLAR BATTERY MODULE AND METHOD FOR PRODUCING SAME, AND MOBILE OBJECT ON WHICH LIGHT TRANSMISSIVE SOLAR BATTERY MODULE IS MOUNTED**

(30) Priority: 05.10.2010 JP 2010225689; 22.01.2010 JP 2010011932
(71) Applicant: Sharp Kabushiki Kaisha, Osaka-shi, Osaka 545-8522 (JP)
(72) Inventor: YAMAMOTO, Kazushi, Osaka 545-8522 (JP); MIZUMAKI, Hidetaka, Osaka 545-8522 (JP); JOHGAN, Shingo, Osaka 545-8522 (JP)
(74) Representative: Hoffmann, Jörg Peter
(86) International application number: PCT/JP2010/072687
(87) International publication number: WO 2011/089804

(57) **Abstract**

A light-transmitting solar cell module is provided in which lines that allow light to pass through other than see-through lines are hidden using a simple structure and method, whereby the cell module has an excellent ability to be designed and can be used as a sunroof for a vehicle. The light-transmitting solar cell module 1 includes a power generation portion having a light-transmitting portion that allows light to pass through. The power generation portion is formed of a plurality of solar cells each including a transparent front surface electrode layer 12, a photoelectric conversion layer 13, and a rear surface electrode layer 14 successively stacked on a translucent insulating substrate 11. The light-transmitting portion includes a third scribe line 17 separating a rear surface electrode layer 14 into portions in order to connect a plurality of solar cells together in series, and a see-through line that allows light to pass through. A non-transparent member 31 is provided on an entire surface of the rear surface electrode layer 14 excluding the see-through line.

## Description

### Technical Field

The present invention relates to light-transmitting solar cell modules including a see-through line that allows light to pass through from the front surface to the rear surface of a power generation portion, methods for manufacturing the light-transmitting solar cell module, and mobile objects including the light-transmitting solar cell module.

### Background Art

Conventionally, a light-transmitting solar cell module has been proposed that has a light admitting function of allowing a portion of incident light to pass through from the front side to the rear side in addition to a power generation function (see, for example, Patent Documents 1 and 2).

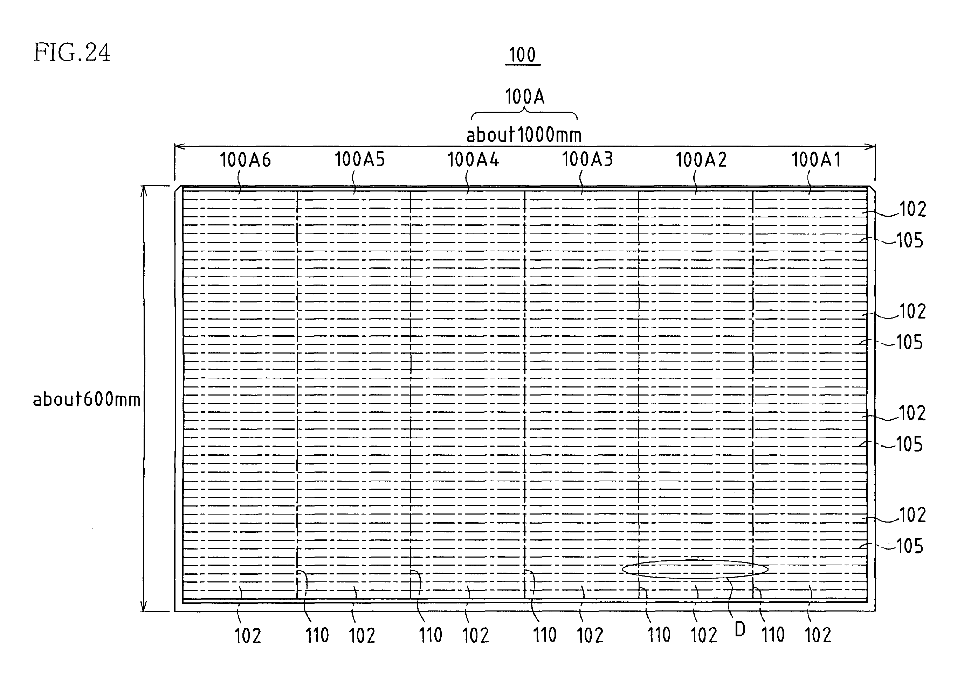

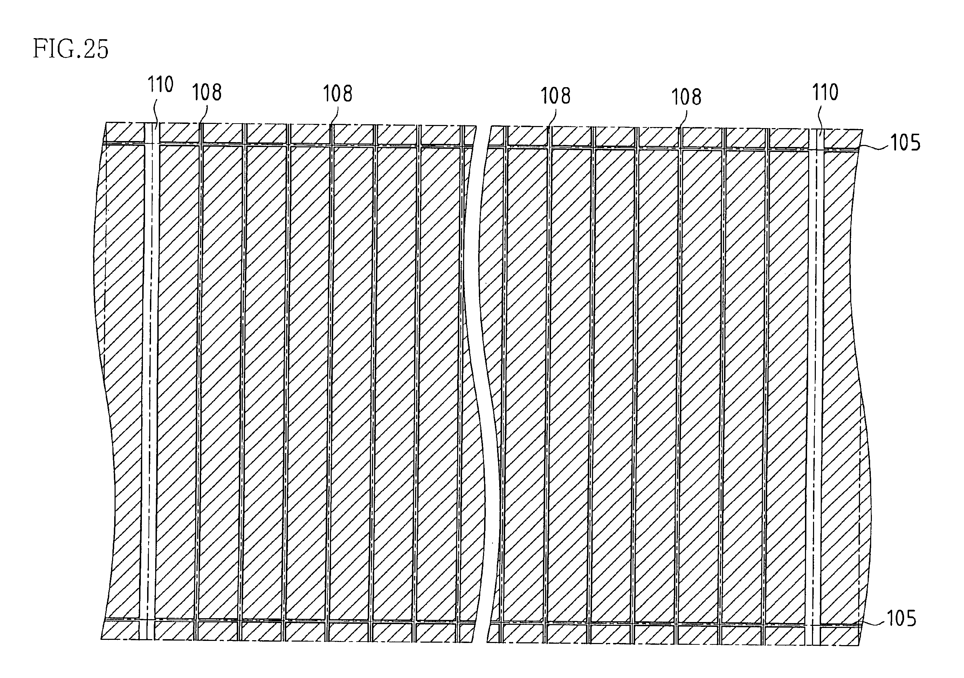

FIG. 24 is a plan view showing an example external appearance and configuration of a conventional light-transmitting solar cell module 100 as viewed from the rear. FIG. 25 is an enlarged view of a portion D of FIG. 24.

The light-transmitting solar cell module 100 is formed in the shape of a horizontal rectangle of about 600 mm (length) by about 1000 mm (width). Although not shown, the light-transmitting solar cell module 100 includes a power generation portion 100A including a plurality of solar cells 102, 102, ... , and 102 that are formed by successively stacking a transparent front surface electrode layer, a photoelectric conversion layer, and a rear surface electrode layer on a translucent insulating substrate formed in the shape of the horizontal rectangle. In this example, the power generation portion 100A is separated into a plurality of power generation regions 100A1-100A6 (in this example, six separate power generation regions) arranged in the widthwise direction by separation lines (separation grooves) 110. Specifically, the separation line 110 is formed to penetrate from the rear surface electrode layer to the translucent insulating substrate and be wide enough to provide a sufficient creepage distance to reduce or prevent the risk of electric discharge between adjacent power generation regions.

The power generation regions 100A1-100A6 each include, for example, forty-nine solar cells 102, 102,..., and 102 that are arranged in the length direction and connected together in series. Therefore, in each of the power generation regions 100A1-100A6, in order to connect the forty-nine solar cells 102 together in series, forty-eight scribe lines (hereinafter also referred to as "third scribe lines") 105 separating the rear surface electrode layer into portions are formed in the widthwise direction and spaced apart from each other by a predetermined spacing. The third scribe line 105 is formed by removing the rear surface electrode layer and the photoelectric conversion layer to reach the front surface electrode layer.

Moreover, in each of the power generation regions 100A1-100A6, as shown in the enlarged view of FIG. 25, a predetermined number of see-through lines 108 for admitting light are formed by removing the rear surface electrode layer and the photoelectric conversion layer to reach the front surface electrode layer. The see-through lines 108 are arranged and spaced apart from each other by a predetermined spacing in the widthwise direction, extending in the lengthwise direction perpendicular to the third scribe lines 105.

Here, the separation line 110 has a line width of, for example, 0.38 mm in order to provide the sufficient creepage distance described above. The see-through line 108 has a line width of, for example, 0.1 mm. The third scribe line 105 has a line width of, for example, 0.08 mm.

In the conventional light-transmitting solar cell module 100 thus configured, for example, the power generation regions 100A1-100A6 are connected together in parallel to provide an output.

As described above, in the conventional light-transmitting solar cell module 100, there are three kinds of lines that allow light to pass through: the see-through line 108 for admitting light; the third scribe line 105 formed by removing the rear surface electrode layer and the photoelectric conversion layer to reach the front surface electrode layer, similar to the see-through line 108; and the separation line 110 formed by removing the rear surface electrode layer, the photoelectric conversion layer, and the front surface electrode layer to reach the translucent insulating substrate.

### Citation List

### Patent Documents

Patent Document 1: JP 2002-43594 A
Patent Document 2: JP 2002-299666 A

### Disclosure of Invention

### Problem to be Solved by the Invention

Incidentally, when such a light-transmitting solar cell module is used in a ceiling of a building etc. to admit light, the lines that allow light to pass through do not cause a particular problem. However, for example, when the light-transmitting solar cell module is mounted as a sunroof on the roof of a vehicle while also serving as an auxiliary power source for the vehicle, the mounted light-transmitting solar cell module is close to a vehicle occupant, and therefore, the third scribe lines 105 and the separation lines 110 as well as the see-through lines 108 are seen or noticed as fine lines by the vehicle occupant. In other words, when looking up and seeing the sunroof, the vehicle occupant can see a lattice pattern of fine lines, resulting in poor appearance. Good appearance is a particularly important factor in vehicles with emphasis on design. Unless this requirement is satisfied, the light-transmitting solar cell module cannot be used as an auxiliary power source that also serves as a sunroof for a vehicle.

In addition to the use of the light-transmitting solar cell module in a ceiling of a building etc. to admit light, the light-transmitting solar cell module is expected to be used as a residential building material etc. in a wide variety of applications. For example, the light-transmitting solar cell module may be used as a wall etc. In this case, the light-transmitting solar cell module is close to a house occupant, and therefore, the third scribe lines 105 and the separation lines 110 as well as the see-through lines 108 are seen or noticed as fine lines by the house occupant.

The present invention has been made in view of the above problems. It is an object of the present invention to provide a light-transmitting solar cell module in which lines that allow light to pass through other than the see-through lines are hidden by a simple structure and therefore that has an excellent ability to be designed and can be used as a sunroof for a vehicle, a residential building material, etc., a method for manufacturing the light-transmitting solar cell module, and a mobile object including the light-transmitting solar cell module.

### Means for Solving Problem

To achieve the object, a light-transmitting solar cell module according to the present invention includes a light-transmitting portion that allows light to pass through from a front surface to a rear surface of a power generation portion. A portion of the light-transmitting portion is covered by an insulating non-transparent member.

Thus, because a portion of the light-transmitting portion is covered by the insulating non-transparent member, portions that are seen or noticed due to light transmission can be reduced. For example, if portions that allow light to pass through are seen or noticed as a lattice pattern of fine lines when viewed from the outside, then when, for example, only lines extending in the widthwise direction are covered by the non-transparent member, lines extending in the lengthwise direction are the only lines that are seen or noticed. In other words, if see-through lines extending in the lengthwise direction are provided, then when light is allowed to pass only through the see-through lines, lines other than the see-through lines can be hidden without impairing the functions (i.e., both the power generation function and the light admission function) of the light-transmitting solar cell module. As a result, if the light-transmitting solar cell module is used as, for example, a sunroof for a vehicle, then when a vehicle occupant looks up and sees the sunroof, the vehicle occupant sees or notices only the lengthwise lines for admitting light, and do not see or notice the fine widthwise lines. Therefore, the light-transmitting solar cell module can have an excellent ability to be designed.

According to the light-transmitting solar cell module of the present invention, the power generation portion may include a plurality of solar cells each including a front surface electrode layer, a photoelectric conversion layer, and a rear surface electrode layer successively stacked on a translucent insulating substrate. The light-transmitting portion may include a plurality of linear opening grooves formed by removing the rear surface electrode layer and the photoelectric conversion layer, and the non-transparent member is provided, corresponding to a portion of the opening grooves.

The linear opening grooves formed by removing the rear surface electrode layer and the photoelectric conversion layer include a see-through line for admitting light and a scribe line for connecting a plurality of solar cells together in series. The scribe line is formed by removing the rear surface electrode layer and the photoelectric conversion layer to reach the front surface electrode layer. Therefore, incident light entering from the front surface of the translucent insulating substrate passes through the translucent insulating substrate and the front surface electrode layer, and then the scribe line, to the rear side (the rear surface electrode layer side). In other words, when viewed from the rear (the rear surface electrode layer side), the scribe line is seen or noticed as a line. Therefore, in the present invention, by providing the non-transparent member on a portion of the opening grooves corresponding to the scribe line, the scribe line is not seen or noticed when viewed from the rear (the rear surface electrode layer side).

According to the light-transmitting solar cell module of the present invention, the light-transmitting portion may include a scribe line separating the rear surface electrode layer into portions in order to connect the plurality of solar cells together in series, and a see-through line that allows light to pass through. The non-transparent member may be provided on an entire surface of the rear surface electrode layer excluding the see-through line.

With this configuration, when the light-transmitting solar cell module is viewed from the rear (the rear surface electrode layer side), the entire rear surface electrode layer is seen as having a whitish silver color because the rear surface electrode layer is made of a silver (Ag)-based material. In the present invention, the non-transparent member having a single color (e.g., a dark color, such as black etc.) is provided (specifically, a dark-colored coating is applied) on the entire portion seen as having the silver color excluding the see-through line, whereby the entire surface of the rear surface electrode layer excluding the see-through line can have a single uniform color. Also, because the non-transparent member is provided on the entire surface of the rear surface electrode layer excluding the see-through line, at least the scribe line that needs to be hidden can be easily covered, and therefore, the non-transparent member does not need to be accurately positioned during formation. In other words, it is not necessary to perform the step of accurately positioning the non-transparent member with respect to the scribe line.

According to the light-transmitting solar cell module of the present invention, the light-transmitting portion may include a scribe line separating the rear surface electrode layer into portions in order to connect the plurality of solar cells together in series, and a see-through line that allows light to pass through. The non-transparent member may be provided on the scribe line excluding the see-through line.

With this configuration, a dark-colored (e.g., black etc.) non-transparent member is provided (specifically, a dark-colored coating is applied) on the scribe line excluding the see-through line (i.e., a portion of the scribe line excluding an intersection portion where the scribe line and the see-through line intersect). Therefore, light passing through the scribe line can be blocked on the rear side (the rear surface electrode layer side) of the light-transmitting solar cell module. Also, in the present invention, the non-transparent member is provided only on the scribe line excluding the see-through line, whereby the amount of the non-transparent member can be reduced or minimized, and therefore, the manufacturing cost (specifically, the cost of the non-transparent member) can be proportionately reduced.

According to the light-transmitting solar cell module of the present invention, the light-transmitting portion may include a scribe line separating the rear surface electrode layer into portions in order to connect the plurality of solar cells together in series, and a see-through line that allows light to pass through. The non-transparent member may be an insulating film including an insulating non-transparent material provided at a portion thereof corresponding to an entire surface of the rear surface electrode layer excluding the see-through line. The film may be attached to the rear surface electrode layer, whereby the entire surface of the rear surface electrode layer excluding the see-through line may be covered with the non-transparent material.

With this configuration, the insulating film including the non-transparent material is only attached to the rear surface electrode layer, whereby light passing through the scribe line can be blocked on the rear side (the rear surface electrode layer side) of the light-transmitting solar cell module. Also, because the non-transparent material included in the film is provided on a portion thereof corresponding to the entire surface of the rear surface electrode layer excluding the see-through line, at least the scribe line that needs to be hidden can be easily covered. Therefore, the non-transparent material may be provided in the film, taking into consideration only the positioning of the region where the non-transparent material is provided with respect to the see-through line, but not with respect to the scribe line that needs to be hidden. Moreover, the non-transparent material allows the entire surface of the rear surface electrode layer excluding the see-through line to have a single uniform color (e.g., black etc.), resulting in an excellent ability to be designed and a muted appearance.

According to the light-transmitting solar cell module of the present invention, the light-transmitting portion may include a scribe line separating the rear surface electrode layer into portions in order to connect the plurality of solar cells together in series, and a see-through line that allows light to pass through. The non-transparent member may be an insulating film including an insulating non-transparent material provided at a portion thereof corresponding to the scribe line excluding the see-through line. The film may be attached to the rear surface electrode layer, whereby the scribe line excluding the see-through line may be covered with the non-transparent material.

With this configuration, the insulating film including the non-transparent material is only attached to the rear surface electrode layer, whereby light passing through the scribe line can be blocked on the rear side (the rear surface electrode layer side) of the light-transmitting solar cell module. Also, the non-transparent material is provided only on the portion corresponding to the scribe line excluding the see-through line (i.e., a portion of the scribe line excluding an intersection portion where the scribe line and the see-through line intersect), whereby the amount of the non-transparent material can be reduced or minimized, and therefore, the manufacturing cost (specifically, the cost of the non-transparent member) can be proportionately reduced.

According to the light-transmitting solar cell module of the present invention, the light-transmitting solar cell module may include a separation line separating the power generation portion into a plurality of power generation regions. The non-transparent member may also be provided on the separation line.

In most large-size light-transmitting solar cell modules, a plurality of power generation regions are formed on a single translucent insulating substrate by forming a separation line or lines for separating the power generation regions from each other. The separation line needs to have a sufficient creepage distance to provide insulation between the adjacent power generation regions, and therefore, inevitably needs to have a large line width. Because the separation line is provided to separate the power generation regions from each other, the separation line has a depth extending from the rear surface electrode layer to the translucent insulating substrate (i.e., the separation line is formed by removing the rear surface electrode layer, the photoelectric conversion layer, and the front surface electrode layer). Therefore, incident light entering from the front surface of the translucent insulating substrate is allowed to easily pass through the translucent insulating substrate and the separation line to the rear surface electrode layer. Therefore, if the non-transparent member is also provided on the separation line, the separation line is also not seen or noticed when viewed from the rear (the rear surface electrode layer side).

According to the light-transmitting solar cell module of the present invention, the light-transmitting solar cell module may include a separation line separating the power generation portion into a plurality of power generation regions. In the film, the non-transparent material may also be provided at a portion thereof corresponding to the separation line.

As described above, the separation line needs to have a sufficient creepage distance to provide insulation between the adjacent power generation regions, and therefore, inevitably needs to have a large line width. Because the separation line is provided to separate the power generation regions from each other, the separation line has a depth extending from the rear surface electrode layer to the translucent insulating substrate (i.e., the separation line is formed by removing the rear surface electrode layer, the photoelectric conversion layer, and the front surface electrode layer). Therefore, incident light entering from the front surface of the translucent insulating substrate is allowed to easily pass through the translucent insulating substrate and the separation line to the rear surface electrode layer. Therefore, if the non-transparent material is also provided on a film portion corresponding to the separation line, because the separation line can be covered with non-transparent material when the film is attached to the rear surface electrode layer, the separation line is also not seen or noticed when viewed from the rear (the rear surface electrode layer side) .

According to the light-transmitting solar cell module of the present invention, the non-transparent member provided on the separation line may be removed along the separation line by a predetermined width.

With this configuration, the non-transparent member provided on the separation line is removed by the predetermined width, whereby the separation line can have a sufficient creepage distance to provide insulation between the adjacent power generation regions.

According to the light-transmitting solar cell module of the present invention, the non-transparent member may have a multilayer structure including a plurality of members having different colors.

With this configuration, the non-transparent member has a multilayer structure including a plurality of members having different colors. Therefore, if a dark-colored (e.g., black) non-transparent member is directly applied to the rear surface electrode layer, and another non-transparent member having the same color as that of a vehicle's interior is applied and stacked on the dark-colored non-transparent member, the light-transmitting solar cell module can have a color matching the vehicle's interior, and therefore, excellent texture and ability to be designed.

According to the light-transmitting solar cell module of the present invention, the non-transparent material may have a multilayer structure including a plurality of materials having different colors.

With this configuration, the non-transparent material included in the film has a multilayer structure including a plurality of materials having different colors. Therefore, when the film is attached to the rear surface electrode layer, then if a dark-colored (e.g., black) non-transparent material is provided to face the rear surface electrode layer, and another non-transparent material having the same color as that of a vehicle's interior is applied and stacked on the dark-colored non-transparent material, the light-transmitting solar cell module can have a color matching the vehicle's interior, and therefore, excellent texture and ability to be designed.

A method for manufacturing a light-transmitting solar cell module according to the present invention is a method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of forming the plurality of solar cells on the translucent insulating substrate, applying a non-transparent member to an entire surface of the rear surface electrode layer after the formation of the solar cells, and forming the see-through line by removing the non-transparent member, the rear surface electrode layer, and the photoelectric conversion layer after the application of the non-transparent member.

When the light-transmitting solar cell module is viewed from the rear (the rear surface electrode layer side), the entire rear surface electrode layer is seen as having a whitish silver color because the rear surface electrode layer is made of a silver (Ag)-based material. According to the manufacturing method of the present invention, the non-transparent member is applied to the entire surface of the rear surface electrode layer, and thereafter, the see-through line is formed by removing the non-transparent member, the rear surface electrode layer, and the photoelectric conversion layer. Therefore, substantially the entire surface of the rear surface electrode layer seen as having the silver color excluding the see-through line can be covered by the non-transparent member having a single color (e.g., a dark color, such as black etc.). As a result, the entire surface of the rear surface electrode layer excluding the see-through line can have a single uniform color. Also, because the non-transparent member is applied to the entire surface of the rear surface electrode layer excluding the see-through line, at least the scribe line that is used to connect a plurality of solar cells together in series and needs to be hidden can be easily covered. Therefore, in the step of applying the non-transparent member, the non-transparent member does not need to be accurately positioned with respect to the scribe line. Therefore, the applying step can be easily performed.

According to the light-transmitting solar cell module manufacturing method of the present invention, the applying step may include applying another non-transparent member to any region on the non-transparent member applied to the entire surface of the rear surface electrode layer. Thus, because another non-transparent member is applied to any region on the non-transparent member applied to the entire surface of the rear surface electrode layer of the light-transmitting solar cell module, any design can be formed on the rear surface of the light-transmitting solar cell module so that the light-transmitting solar cell module matches the surrounding design of a place where the light-transmitting solar cell module is installed.

A method for manufacturing a light-transmitting solar cell module according to the present invention is a method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through. The method includes the steps of forming the plurality of solar cells on the translucent insulating substrate, forming the see-through line by removing the rear surface electrode layer and the photoelectric conversion layer after the formation of the solar cells, and applying a non-transparent member to a scribe line that is formed during the formation of the plurality of solar cells to separate the rear surface electrode layer into portions in order to connect the plurality of solar cells together in series.

According to the manufacturing method of the present invention, a dark-colored (e.g., black etc.) non-transparent member is applied (specifically, a dark-colored coating is applied) to the scribe line excluding the see-through line (i.e., a portion of the scribe line excluding an intersection portion where the scribe line and the see-through line intersect). Therefore, light passing through the scribe line can be blocked on the rear side (the rear surface electrode layer side) of the light-transmitting solar cell module. Also, in the present invention, the non-transparent member is applied only to the scribe line excluding the see-through line, whereby the amount of the non-transparent member can be reduced or minimized, and therefore, the manufacturing cost (specifically, the cost of the non-transparent member) can be proportionately reduced.

A method for manufacturing a light-transmitting solar cell module according to the present invention is a method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through. The method includes the steps of forming the plurality of solar cells on the translucent insulating substrate, forming the see-through line by removing the rear surface electrode layer and the photoelectric conversion layer after the formation of the solar cells, first applying a non-transparent member to a region where the rear surface electrode layer is provided and/or to a region where the rear surface electrode layer is not provided but light is desired to be blocked, and second applying another non-transparent member to any region on the applied non-transparent member.

According to the manufacturing method of the present invention, the method includes the first applying a non-transparent member to a region where the rear surface electrode layer is provided and/or to a region where the rear surface electrode layer is not provided but light is desired to be blocked, and the second applying another non-transparent member to any region on the applied non-transparent member. Therefore, any design can be formed on the rear surface of the light-transmitting solar cell module so that the light-transmitting solar cell module matches the surrounding design of a place where the light-transmitting solar cell module is installed.

A method for manufacturing a light-transmitting solar cell module according to the present invention is a method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through. The method includes the steps of forming the plurality of solar cells on the translucent insulating substrate, forming the see-through line by removing the rear surface electrode layer and the photoelectric conversion layer after the formation of the solar cells, and attaching to the rear surface electrode layer an insulating film including an insulating non-transparent material at a portion thereof corresponding to an entire surface of the rear surface electrode layer excluding the see-through line.

According to the manufacturing method of the present invention, the film is attached to the rear surface electrode layer, whereby the entire surface of the rear surface electrode layer excluding the see-through line can have a single color that is the color (e.g., a dark color, such as black etc.) of the non-transparent material. Also, because the non-transparent material is provided at a film portion corresponding to the entire surface of the rear surface electrode layer excluding the see-through line, at least the scribe line that is used to connect a plurality of solar cells together in series and needs to be hidden can be easily covered.

A method for manufacturing a light-transmitting solar cell module according to the present invention is a method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through. The method includes the steps of forming the plurality of solar cells on the translucent insulating substrate, forming the see-through line by removing the rear surface electrode layer and the photoelectric conversion layer after the formation of the solar cells, and attaching to the rear surface electrode layer an insulating film including an insulating non-transparent material at a portion thereof corresponding to the scribe line excluding the see-through line.

According to the manufacturing method of the present invention, the film is attached to the rear surface electrode layer, whereby the scribe line excluding the see-through line (i.e., a portion of the scribe line excluding an intersection portion where the scribe line and the see-through line intersect) can be reliably covered with the non-transparent material. As a result, light passing through the scribe line can be blocked on the rear side (the rear surface electrode layer side) of the light-transmitting solar cell module. Also, in the present invention, the non-transparent material is provided only at the film portion corresponding to the scribe line excluding the see-through line, whereby the amount of the non-transparent member can be reduced or minimized, and therefore, the manufacturing cost (specifically, the cost of the non-transparent member) can be proportionately reduced.

According to the light-transmitting solar cell module manufacturing method of the present invention, the light-transmitting solar cell module may include a separation line separating the power generation portion into a plurality of power generation regions. In the applying step, the non-transparent member may also be applied to the separation line.

In most large-size light-transmitting solar cell modules, a plurality of power generation regions are formed on a single translucent insulating substrate by forming a separation line or lines for separating the power generation regions from each other. The separation line needs to have a sufficient creepage distance to provide insulation between the adjacent power generation regions, and therefore, inevitably needs to have a large line width. Because the separation line is provided to separate the power generation regions from each other, the separation line has a depth extending from the rear surface electrode layer to the translucent insulating substrate (i.e., the separation line is formed by removing the rear surface electrode layer, the photoelectric conversion layer, and the front surface electrode layer). Therefore, incident light entering from the front surface of the translucent insulating substrate is allowed to easily pass through the translucent insulating substrate and the separation line to the rear surface electrode layer. Therefore, if the non-transparent member is also provided on the separation line, the separation line is also not seen or noticed when viewed from the rear (the rear surface electrode layer side).

According to the light-transmitting solar cell module manufacturing method of the present invention, the light-transmitting solar cell module may include a separation line separating the power generation portion into a plurality of power generation regions. In the film, the non-transparent material may also be provided at a portion thereof corresponding to the separation line.

As described above, because the separation line is provided to separate the power generation regions from each other, the separation line has a depth extending from the rear surface electrode layer to the translucent insulating substrate (i.e., the separation line is formed by removing the rear surface electrode layer, the photoelectric conversion layer, and the front surface electrode layer). Therefore, incident light entering from the front surface of the translucent insulating substrate is allowed to easily pass through the translucent insulating substrate and the separation line to the rear surface electrode layer. Therefore, if the non-transparent material is also provided at the film portion corresponding to the separation line, the separation line is also not seen or noticed when viewed from the rear (the rear surface electrode layer side).

A mobile object according to the present invention includes as a sunroof a light-transmitting solar cell module according to any of the above embodiments.

When the light-transmitting solar cell module is mounted as a sunroof on the roof of a vehicle while also serving as an auxiliary power source for the vehicle, the mounted light-transmitting solar cell module is close to a vehicle occupant, and therefore, the scribe line for connecting a plurality of solar cells together in series and the separation line separating the power generation portion into a plurality of power generation regions as well as the see-through line are seen or noticed as fine lines by the vehicle occupant. In the light-transmitting solar cell module of the present invention, the scribe line and the separation line are not seen or noticed, and therefore, even when the light-transmitting solar cell module is used as a sunroof, the light-transmitting solar cell module can have an excellent ability to be designed.

### Effects of the Invention

According to the light-transmitting solar cell module of the present invention, a portion of the light-transmitting portion is covered by the insulating non-transparent member, whereby portions that are seen or noticed due to light transmission can be reduced. For example, if portions that allow light to pass through are seen or noticed as a lattice pattern of fine lines when viewed from the outside, then when, for example, only lines extending in the widthwise direction are covered by the non-transparent member, lines extending in the lengthwise direction are the only lines that are seen or noticed. In other words, if see-through lines extending in the lengthwise direction are provided, then when light is allowed to pass only through the see-through lines, lines other than the see-through lines can be hidden without impairing the functions (i.e., both the power generation function and the light admission function) of the light-transmitting solar cell module. As a result, if the light-transmitting solar cell module is used as, for example, a sunroof for a vehicle, then when a vehicle occupant looks up and sees the sunroof, the vehicle occupant sees or notices only the lengthwise lines for admitting light, and do not see or notice the fine widthwise lines. Therefore, the light-transmitting solar cell module can have an excellent ability to be designed.

According to the light-transmitting solar cell module manufacturing method of the present invention, the non-transparent member is applied to the entire surface of the rear surface electrode layer, and thereafter, the see-through line is formed by removing the non-transparent member, the rear surface electrode layer, and the photoelectric conversion layer. Therefore, substantially the entire surface of the rear surface electrode layer excluding the see-through line can be covered by the non-transparent member having a single color (e.g., a dark color, such as black etc.). Also, because the non-transparent member is applied to the entire surface of the rear surface electrode layer excluding the see-through line, at least the scribe line that is used to connect a plurality of solar cells together in series and needs to be hidden can be easily covered. Therefore, in the step of applying the non-transparent member, the non-transparent member does not need to be accurately positioned with respect to the scribe line. Therefore, the applying step can be easily performed.

According to the light-transmitting solar cell module manufacturing method of the present invention, a dark-colored (e.g., black etc.) non-transparent member is applied to the scribe line excluding the see-through line. Therefore, light passing through the scribe line can be blocked on the rear side (the rear surface electrode layer side) of the light-transmitting solar cell module. Also, the non-transparent member is applied only to the scribe line excluding the see-through line, whereby the amount of the non-transparent member can be reduced or minimized, and therefore, the manufacturing cost (specifically, the cost of the non-transparent member) can be proportionately reduced.

According to the light-transmitting solar cell module manufacturing method of the present invention, by attaching the film to the rear surface electrode layer, the entire surface of the rear surface electrode layer excluding the see-through line can have a single color that is the color (e.g., a dark color, such as black etc.) of the non-transparent material. Also, because the non-transparent material is provided at a film portion corresponding to the entire surface of the rear surface electrode layer excluding the see-through line, at least the scribe line that is used to connect a plurality of solar cells together in series and needs to be hidden can be easily covered.

According to the light-transmitting solar cell module manufacturing method of the present invention, by attaching the film to the rear surface electrode layer, the scribe line excluding the see-through line can be covered with the non-transparent material. As a result, light passing through the scribe line can be blocked on the rear side (the rear surface electrode layer side) of the light-transmitting solar cell module. Also, the non-transparent material is provided only at the film portion corresponding to the scribe line excluding the see-through line, whereby the amount of the non-transparent member can be reduced or minimized, and therefore, the manufacturing cost (specifically, the cost of the non-transparent member) can be proportionately reduced.

According to the light-transmitting solar cell module manufacturing method of the present invention, the non-transparent member is also provided on the separation line separating the power generation portion into a plurality of power generation regions, whereby the separation line is also not seen or noticed when viewed from the rear (the rear surface electrode layer side).

According to the mobile object including the light-transmitting solar cell module of the present invention, even when the light-transmitting solar cell module is mounted as a sunroof in a roof of a vehicle body while also serving as an auxiliary power source for the vehicle, the scribe line and the separation line are not seen or noticed from the vehicle's interior, and therefore, the light-transmitting solar cell module of the present invention can be used as a sunroof having an excellent ability to be designed.

### Brief Description of Drawings

[FIG. 1] FIG. 1 is a plan view showing a basic configuration of a light-transmitting solar cell module as viewed from the rear (opposite to the light reception surface).
[FIG. 2] FIG. 2 is an enlarged view of a portion A of the light-transmitting solar cell module of FIG. 1.
[FIG. 3] FIG. 3 is a partially enlarged cross-sectional view of the portion A of the light-transmitting solar cell module of FIG. 1 as viewed in an X direction.
[FIG. 4] FIG. 4 is a partially enlarged cross-sectional view of the portion A of the light-transmitting solar cell module of FIG. 1 as viewed in a Y direction.
[FIG. 5] FIG. 5 is a partially enlarged plan view of an external appearance and configuration of the light-transmitting solar cell module 1 of Example 1 as viewed from the rear, showing a further enlarged view of a portion B of FIG. 2.
[FIG. 6A] FIG. 6A is a cross-sectional view taken along line J1-J1 of FIG. 5.
[FIG. 6B] FIG. 6B is a cross-sectional view taken along line J2-J2 of FIG. 5.
[FIG. 7] FIG. 7 is a partially enlarged plan view of an external appearance and configuration of the light-transmitting solar cell module 1 of Example 2 as viewed from the rear, showing a further enlarged view of the portion B of FIG. 2.
[FIG. 8A] FIG. 8A is a cross-sectional view taken along line K1-K1 of FIG. 7.
[FIG. 8B] FIG. 8B is a cross-sectional view taken along line K2-K2 of FIG. 8.
[FIG. 9] FIG. 9 is a partially enlarged plan view of an external appearance and configuration of the light-transmitting solar cell module 1 of Example 3 as viewed from the rear, showing a further enlarged view of the portion B of FIG. 2.
[FIG. 10] FIG: 10 is a partially enlarged plan view showing the light-transmitting solar cell module of FIG. 9 and an insulating film, separately.
[FIG. 11A] FIG. 11A is a cross-sectional view taken along line L1-L1 of FIG. 9.
[FIG. 11B] FIG. 11B is a cross-sectional view taken along line L2-L2 of FIG. 9.
[FIG. 12] FIG. 12 is a partially enlarged plan view of an external appearance and configuration of the light-transmitting solar cell module 1 of Example 4 as viewed from the rear, showing a further enlarged view of the portion B of FIG. 2.
[FIG. 13] FIG. 13 is a partially enlarged plan view showing the light-transmitting solar cell module of FIG. 12 and an insulating film, separately.
[FIG. 14A] FIG. 14A is a cross-sectional view taken along line M1-M1 of FIG. 12.
[FIG. 14B] FIG. 14B is a cross-sectional view taken along line M2-M2 of FIG. 12.
[FIG. 15A] FIG. 15A is a partially enlarged plan view of the light-transmitting solar cell module 1 as viewed from the rear, showing a step in a manufacturing method of Example 5.
[FIG. 15B] FIG. 15B is a partially enlarged plan view of the light-transmitting solar cell module 1 as viewed from the rear, showing a step in the manufacturing method of Example 5.
[FIG. 15C] FIG. 15C is a partially enlarged plan view of the light-transmitting solar cell module 1 as viewed from the rear, showing a step in the manufacturing method of Example 5.
[FIG. 16] FIG. 16 is a cross-sectional view taken along line N1-N1 of FIG. 15C.
[FIG. 17A] FIG. 17A is a partially enlarged plan view of the light-transmitting solar cell module 1 as viewed from the rear, showing a step in a manufacturing method of Example 6.
[FIG. 17B] FIG. 17B is a partially enlarged plan view of the light-transmitting solar cell module 1 as viewed from the rear, showing a step in the manufacturing method of Example 6.
[FIG. 17C] FIG. 17C is a partially enlarged plan view of the light-transmitting solar cell module 1 as viewed from the rear, showing a step in the manufacturing method of Example 6.
[FIG. 17D] FIG. 17D is a partially enlarged plan view of the light-transmitting solar cell module 1 as viewed from the rear, showing a step in the manufacturing method of Example 6.
[FIG. 18] FIG. 18 is a cross-sectional view taken along line P1-P1 of FIG. 17D.
[FIG. 19A] FIG. 19A is a partially enlarged plan views of the light-transmitting solar cell module 1 as viewed from the rear, showing a step in a manufacturing method of Example 7.
[FIG. 19B] FIG. 19B is a partially enlarged plan views of the light-transmitting solar cell module 1 as viewed from the rear, showing a step in the manufacturing method of Example 7.
[FIG. 20] FIG. 20 is a cross-sectional view taken along line Q1-Q1 of FIG. 19B.
[FIG. 21A] FIG. 21A is a partially enlarged plan views of the light-transmitting solar cell module 1 as viewed from the rear, showing a step in a manufacturing method of Example 8.
[FIG. 21B] FIG. 21B is a partially enlarged plan views of the light-transmitting solar cell module 1 as viewed from the rear, showing a step in the manufacturing method of Example 8.
[FIG. 21C] FIG. 21C is a partially enlarged plan views of the light-transmitting solar cell module 1 as viewed from the rear, showing a step in the manufacturing method of Example 8.
[FIG. 22] FIG. 22 is a cross-sectional view taken along line R1-R1 of FIG. 21C.
[FIG. 23] FIG. 23 is a perspective view showing a general configuration of a vehicle including as a sunroof a light-transmitting solar cell module according to an embodiment of the present invention.
[FIG. 24] FIG. 24 is a plan view showing an example external appearance and configuration of a conventional light-transmitting solar cell module as viewed from the rear.
[FIG. 25] FIG. 25 is an enlarged view of a portion D of FIG. 24. Description of the Invention

Embodiments of the present invention will be described hereinafter with reference to the accompanying drawings. Note that the embodiments described below are intended to clarify the present invention and are not intended to limit the scope of the present invention.

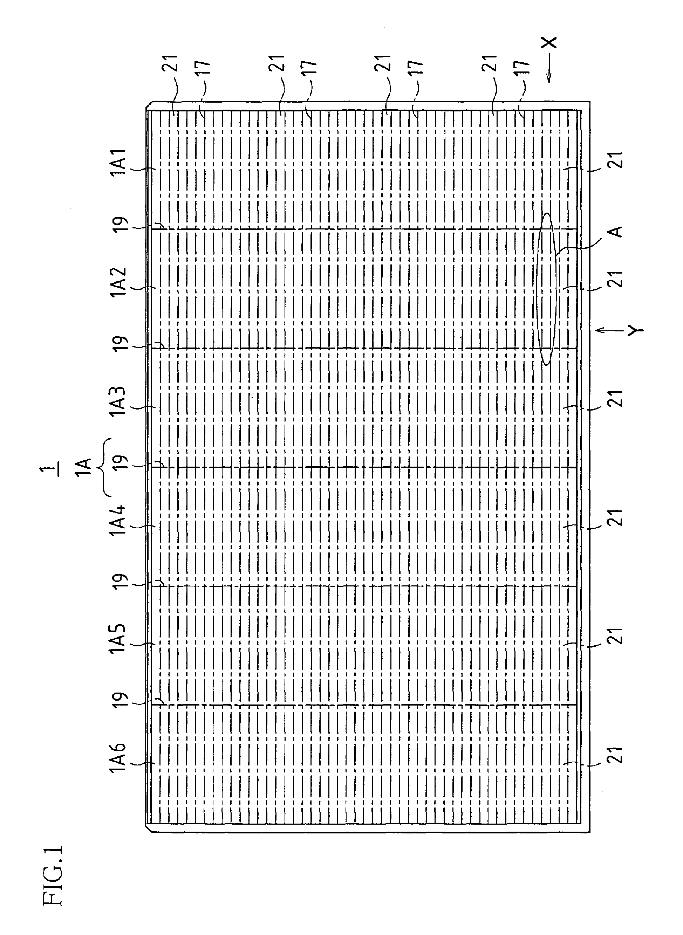

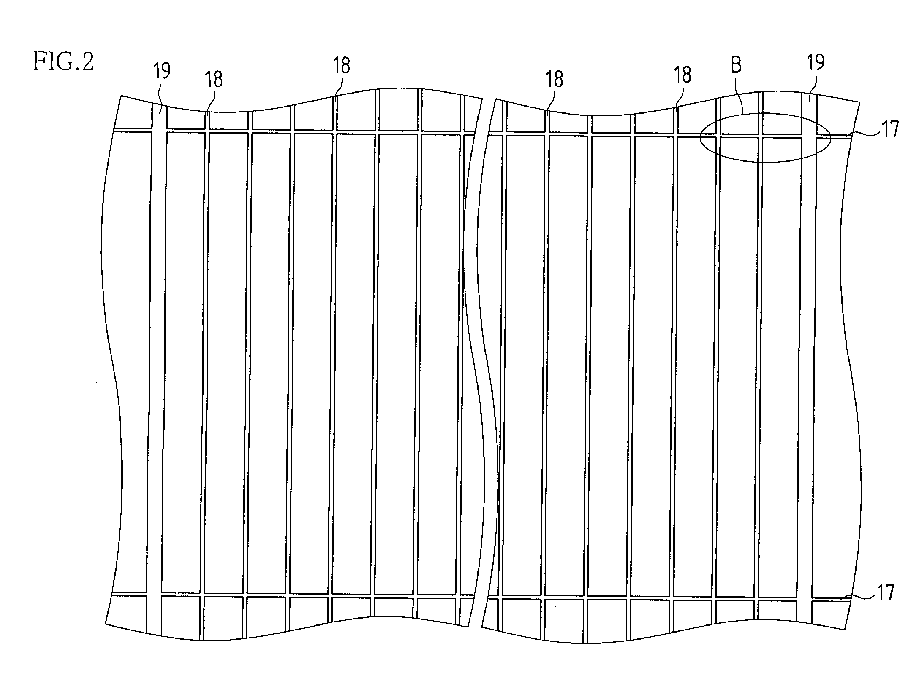

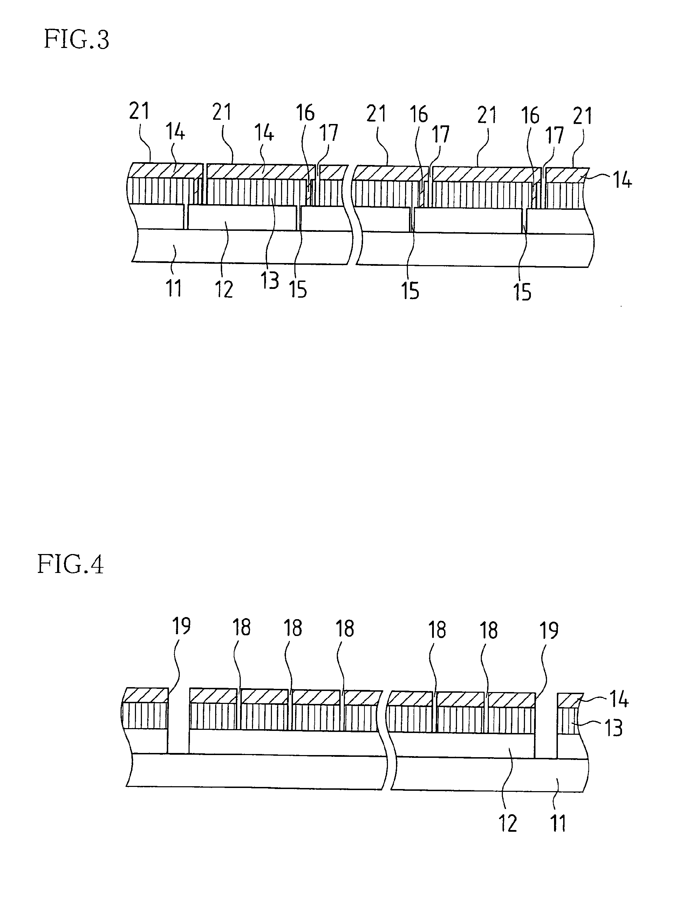

FIG. 1 is a plan view showing a basic configuration of a light-transmitting solar cell module as viewed from the rear (opposite to the light reception surface). FIG. 2 is an enlarged view of a portion A of the light-transmitting solar cell module of FIG. 1. FIG. 3 is a partially enlarged cross-sectional view of the portion A of the light-transmitting solar cell module of FIG. 1 as viewed in an X direction. FIG. 4 is a partially enlarged cross-sectional view of the portion A of the light-transmitting solar cell module of FIG. 1 as viewed in a Y direction.

Firstly, a basic configuration of the light-transmitting solar cell module 1 will be described with reference to FIGS. 1-4.

The light-transmitting solar cell module 1 of the present invention is formed in the shape of a horizontal rectangle of, for example, about 600 mm (length) by about 1000 mm (width). The light-transmitting solar cell module 1 includes a power generation portion 1A including a plurality of solar cells 21, 21, ... , and 21 that are formed by successively stacking a transparent front surface electrode layer 12, a photoelectric conversion layer 13, and a rear surface electrode layer 14 on a translucent insulating substrate 11 formed in the shape of the horizontal rectangle. In this embodiment, the power generation portion 1A is separated into a plurality of power generation regions 1A1-1A6 (in this example, six separate power generation regions) arranged in the widthwise direction by separation lines (separation grooves) 19 described below. Specifically, the separation line 19 is formed by removing the rear surface electrode layer 14, the photoelectric conversion layer 13, and the front surface electrode layer 12 to reach the translucent insulating substrate 11 and is wide enough to provide a sufficient creepage distance.

The power generation regions 1A1-1A6 each include, for example, forty-nine solar cells 21, 21, ... , and 21 that are arranged in the length direction of FIG. 1 and connected together in series. Therefore, in each of the power generation regions 1A1-1A6, in order to connect the forty-nine solar cells 21 together in series, forty-eight third scribe lines 17 separating the rear surface electrode layer 14 into portions are formed in the widthwise direction and spaced apart from each other by a predetermined spacing. Specifically, the third scribe line 17 is formed by removing the rear surface electrode layer 14 and the photoelectric conversion layer 13 to reach the front surface electrode layer 12.

Moreover, in each of the power generation regions 1A1-1A6, as shown in the enlarged view of FIG. 2, a predetermined number of see-through lines 18 for admitting light are formed by removing the rear surface electrode layer 14 and the photoelectric conversion layer 13 to reach the front surface electrode layer 12. The see-through lines 18 are arranged and spaced apart from each other by a predetermined spacing in the widthwise direction, extending in the lengthwise direction perpendicular to the third scribe lines 17.

Here, the separation line 19 has a line width of, for example, 0.38 mm in order to provide the sufficient creepage distance described above. The see-through line 18 has a line width of, for example, 0.1 mm. The third scribe line 17 has a line width of, for example, 0.08 mm.

In the light-transmitting solar cell module 1 thus configured, the power generation regions 1A1-1A6 are connected together in parallel to provide an output.

The translucent insulating substrate 11 may be made of glass etc. The front surface electrode layer 12 may be made of a transparent conductive oxide (TCO), which can transmit light, such as zinc oxide (ZnO), ITO (indium tin oxide), tin chloride (II) (SnCl2), or the like. The photoelectric conversion layer 13 may have, for example, a structure formed by successively stacking a p-layer, an i-layer, and an n-layer each made of a semiconductor thin film. The semiconductor thin film may be, for example, an amorphous silicon thin film, a crystalline silicon thin film, or a combination thereof.

The rear surface electrode layer 14 may be formed of a layer of a conductive oxide, such as ZnO etc., and a layer of a metal, such as silver, silver alloy, etc. More typically, for example, the rear surface electrode layer 14 may have a multilayer structure of ZnO/Ag.

Next, a method for manufacturing (fabricating) the light-transmitting solar cell module 1 having the above configuration will be described.

Initially, the front surface electrode layer 12 made of, for example, tin oxide (SnO₂) is formed on the translucent insulating substrate 11, such as a glass substrate etc., by thermal CVD or the like (this step is referred to as "step 1").

Next, the front surface electrode layer 12 is patterned using the fundamental wave (wavelength: 1064 nm) of YAG laser or the like. Specifically, the laser light is caused to enter from the front surface (the lower surface in FIGS. 3 and 4) of the translucent insulating substrate 11, whereby the front surface electrode layer 12 is separated into strips by laser scribing to form separation lines (first scribe lines) 15 (this step is referred to as "step 2").

Next, ultrasonic washing is performed using pure water to form the photoelectric conversion layer 13. As the photoelectric conversion layer 13, for example, an upper (closer to the light reception surface) cell including an a-Si:Hp layer and an a-Si:Hi layer and a lower cell including a µc-Si:Hp layer and a µc-Si:Hn layer are formed(this step is referred to as "step 3").

Next, the photoelectric conversion layer 13 is patterned using, for example, the second harmonic wave (wavelength: 532 nm) of YAG laser, or YVO₄ laser. Specifically, the laser light is caused to enter from the front surface of the translucent insulating substrate 11, whereby the photoelectric conversion layer 13 is separated into strips by laser scribing to form contact lines (second scribe lines) 16 that electrically connect the front surface electrode layer 12 and the rear surface electrode layer 14 together (this step is referred to as "step 4").

Next, the rear surface electrode layer 14 made of zinc oxide (ZnO)/Ag is formed by magnetron sputtering (this step is referred to as "step 5"). The ZnO layer may have a thickness of about 50 nm. Note that a highly transparent film made of ITO, SnO_{2,} or the like may be used instead of ZnO. The Ag layer may have a thickness of about 125 nm. Note that, in the rear surface electrode layer 14, the above transparent conductive film of ZnO or the like may be removed, but is preferably used in order to obtain high conversion efficiency.

Next, the photoelectric conversion layer 13 and the rear surface electrode layer 14 are patterned using, for example, the second harmonic wave (wavelength: 532 nm) of YAG laser, or YVO₄ laser. Specifically, the laser light is caused to enter from the front surface of the translucent insulating substrate 11, whereby the photoelectric conversion layer 13 and the rear surface electrode layer 14 are separated into strips by laser scribing to form separation lines (third scribe lines) 17 that reach the front surface electrode layer 12 (this step is referred to as "step 6"). In this case, processing conditions are preferably selected under which damage to the front surface electrode layer 12 is reduced or minimized, and the occurrence of burr in a silver electrode obtained after processing of the rear surface electrode layer 14 is reduced.

Next, in order to form the separation lines 19 that separate the power generation portion 1A into the six power generation regions 1A1-1A6, the front surface electrode layer 12, the photoelectric conversion layer 13, and the rear surface electrode layer 14 are patterned using, for example, the second harmonic wave (wavelength: 532 nm) of YAG laser, or YVO₄ laser. Specifically, the laser light is caused to enter from the front surface of the translucent insulating substrate 11, whereby the front surface electrode layer 12, the photoelectric conversion layer 13, and the rear surface electrode layer 14 are removed from boundaries between the power generation regions by laser scribing to form grooves, i.e., the separation lines 19 having a predetermined width that reach the translucent insulating substrate 11 (this step is referred to as "step 7").

Finally, in order to form see-through lines that allow incident light from the front surface (light reception surface) of the translucent insulating substrate 11 to pass through to the rear surface electrode layer 14, the photoelectric conversion layer 13 and the rear surface electrode layer 14 are patterned using, for example, the second harmonic wave (wavelength: 532 nm) of YAG laser, or YVO₄ laser. Specifically, the laser light is caused to enter from the front surface of the translucent insulating substrate 11, whereby the photoelectric conversion layer 13 and the rear surface electrode layer 14 are separated into strips by laser scribing to form the separation lines (see-through lines) 18 that reach the front surface electrode layer 12 (this step is referred to as "step 8"). In this case, the amount or proportion of light admitted can be arbitrarily set by changing the number of see-through lines 18 and the line width of each see-through line 18. In this embodiment, the see-through lines 18 that allow light to pass through occupy about 10-13% of the entire power generation region.

The light-transmitting solar cell module 1 having the configuration of FIGS. 1-4 is thus fabricated.

In the light-transmitting solar cell module 1 thus configured, as described in the above Background Art section, there are three kinds of lines that allow light to pass through (light-transmitting portions): the see-through line 18 for admitting light; the third scribe line 17 formed by removing the rear surface electrode layer 14 and the photoelectric conversion layer 13, similar to the see-through line 18; and the separation line 19 formed by removing the rear surface electrode layer 14, the photoelectric conversion layer 13, and the front surface electrode layer 12 to separate the power generation portion 1A into the power generation regions 1A1-1A6. Note that, as described above, the see-through line 18 and the third scribe line 17 are each a linear opening groove formed by removing the rear surface electrode layer 14 and the photoelectric conversion layer 13.

If the light-transmitting solar cell module 1 is used as a sunroof of a vehicle, all of these lines are seen or noticed from the interior of the vehicle, resulting in poor appearance.

Here, the see-through line 18 is the only line required to allow light to pass through, while the third scribe line 17 and the separation line 19 are normally not required to allow light to pass through. Therefore, in the present invention, the third scribe line 17 and the separation line 19 that are not required to allow light to pass through are covered with a non-transparent member.

The light-transmitting solar cell module 1 of this embodiment will be specifically described hereinafter.

### <Example 1>

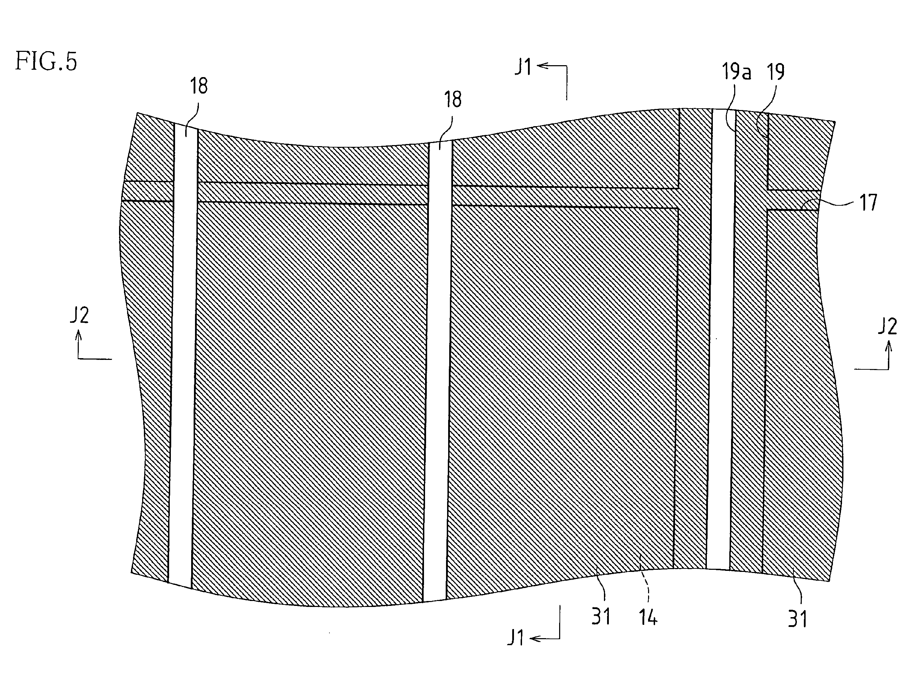

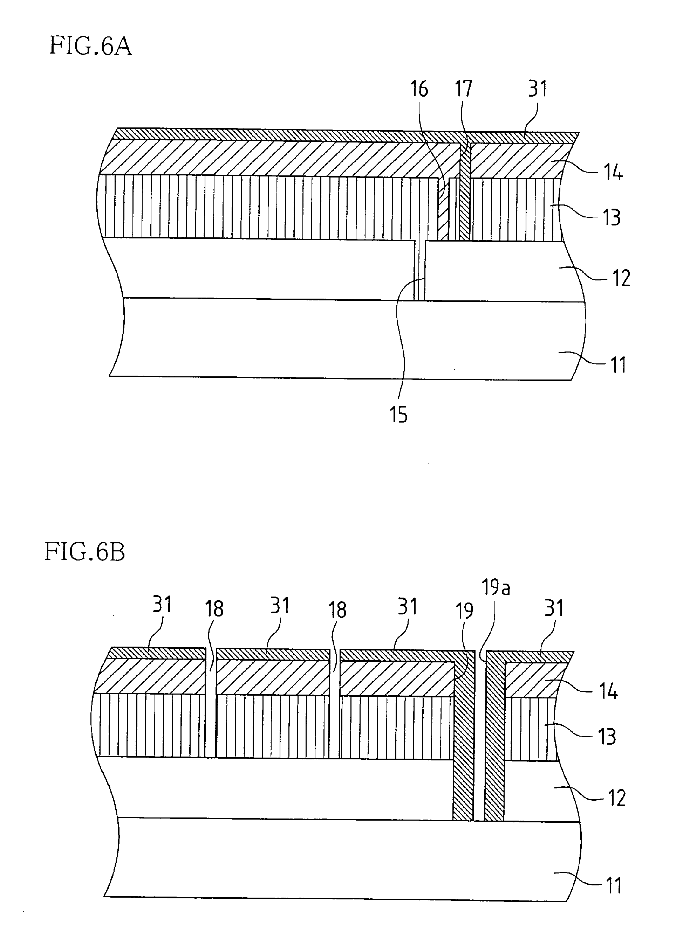

FIG. 5 is a partially enlarged plan view of an external appearance and configuration of the light-transmitting solar cell module 1 of Example 1 as viewed from the rear, showing a further enlarged view of a portion B of FIG. 2. FIG. 6A is a cross-sectional view taken along line J1-J1 of FIG. 5. FIG. 6B is a cross-sectional view taken along line J2-J2 of FIG. 5.

In the light-transmitting solar cell module 1 of Example 1, a non-transparent member 31 made of a non-conductive material is provided on an entire surface excluding the see-through lines 18 of the rear surface electrode layer 14. In other words, the third scribe lines 17 and the separation lines 19 are covered by the non-transparent member 31 (specifically, the third scribe lines 17 and the separation lines 19 are filled with the non-transparent member 31).

Note that, in FIGS. 5, 6A, and 6B, the separation line 19 is not entirely covered. A removal line 19a is formed by removing the non-transparent member 31 from a middle portion in the widthwise direction that extends along the separation line 19 and has a predetermined width (in this example, substantially the same width as that of the see-through line 18). The removal line 19a is provided, taking the creepage distance into consideration, in order to reduce or avoid the risk of electric discharge between the adjacent power generation regions. If the non-transparent member 31 is formed of a non-conductive material, the risk of electric discharge between the adjacent power generation regions is reduced or avoided, and it is not necessary to take the creepage distance into consideration. Therefore, the removal line 19a having the predetermined width is not necessarily required. In other words, the entire surface of the separation line 19 may also be covered by the non-transparent member 31.

With this configuration, light passing through the third scribe line 17 and the separation line 19 can be blocked by the non-transparent member 31 on the rear side (the rear surface electrode layer 14 side) of the light-transmitting solar cell module 1. If the non-transparent member 31 is made of a dark-colored (e.g., black etc.) material, the entire surface excluding the see-through lines 18 of the rear surface electrode layer 14 is allowed to have a single uniform color (e.g., a dark color, such as black etc.) when the light-transmitting solar cell module 1 is viewed from the rear (the rear electrode layer 14 side). In other words, when the light-transmitting solar cell module 1 is viewed from the rear (the rear electrode layer 14 side), the see-through line 18 is the only line that is seen or noticed.

The non-transparent member 31 may be made of a resin material (coating), such as polyester-melamine, acrylic-melamine, etc., and are not particularly limited to these resin materials. Note that the same applies to the material of the non-transparent member 31 of Example 2.

Next, a method for manufacturing the light-transmitting solar cell module 1 of Example 1 will be described.

After steps 1-7 have been finished (i.e., before the formation of the see-through line), the non-transparent member 31 is uniformly applied to the entire surface of the rear surface electrode layer 14 of the light-transmitting solar cell module 1. As a result, the non-transparent member 31 in the form of a film is applied to the entire surface of the rear surface electrode layer 14, and the third scribe lines 17 and the separation lines 19 are filled with the non-transparent member 31. Specifically, the non-transparent member 31 is made of a material that is viscous but can fill the lines without leaving a space.

For example, the non-transparent member 31 may be applied by so-called roll application. Specifically, while a predetermined amount of a coating (the non-transparent member 31) is invariably attached to a roll, a roller is moved on the surface of the rear surface electrode layer 14 at a predetermined speed in a predetermined direction to transfer the coating to the surface of the rear surface electrode layer 14. In the case of roll application, the resultant coating film typically has a thickness on the order of several tens of micrometers, but the thickness of the coating film is not particularly limited. The process of applying the non-transparent member 31 is not limited to roll application. Other conventionally well-known techniques may be used.

Next, step 8 is performed on the light-transmitting solar cell module 1 to which the non-transparent member 31 has been thus applied, to remove the non-transparent member 31, the rear surface electrode layer 14, and the photoelectric conversion layer 13, thereby forming the see-through line 18 that reaches the front surface electrode layer 12.

Note that, when the removal line 19a is required in the separation line 19, step 7 may be performed again (in this time, the line width is changed to the width of the removal line 19a) after step 8. As a result, the light-transmitting solar cell module 1 having the plan-view structure of FIG. 5 and the cross-sectional structure of FIGS. 6A and 6B can be fabricated.

According to the above manufacturing method, the non-transparent member 31 is applied to the entire surface of the rear surface electrode layer 14 before the see-through line 18 penetrating the non-transparent member 31 and the like and thereby reaching the front surface electrode layer 12 is formed. In other words, the non-transparent member 31 is applied to the entire surface excluding the see-through lines 18 of the rear surface electrode layer 14, whereby at least the third scribe line 17 that needs to be hidden can be easily covered. Therefore, in the step of applying the non-transparent member 31, the step of accurately positioning the non-transparent member 31 on the third scribe line 17 is not required. Therefore, the application step can be easily performed.

### <Example 2>

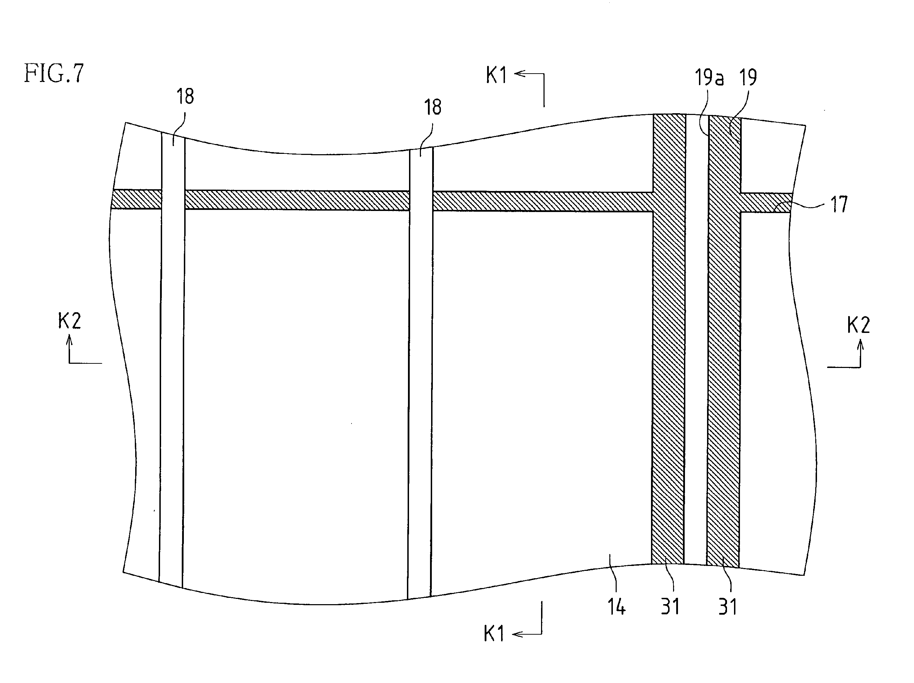

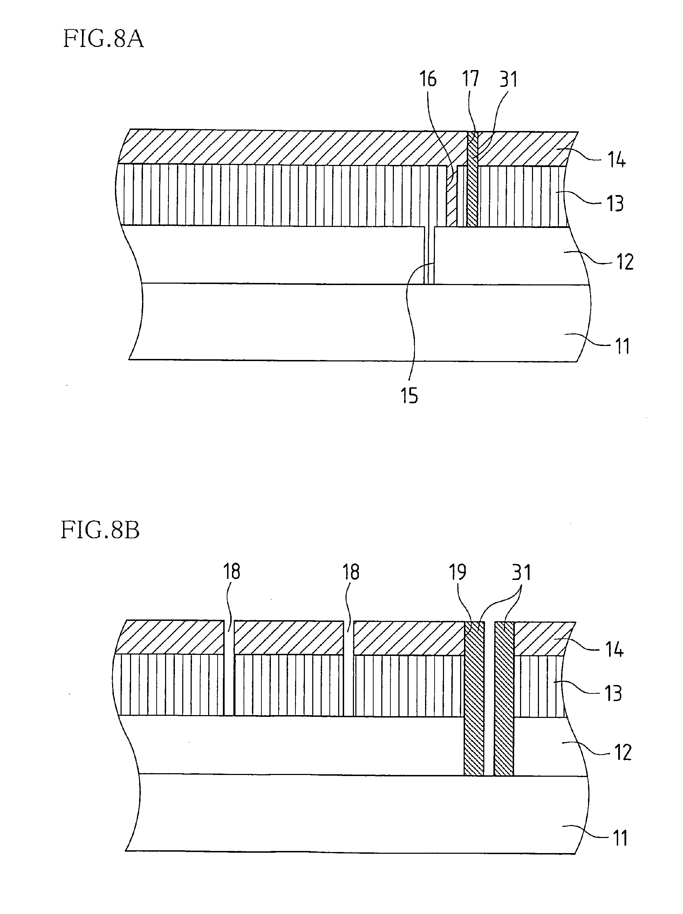

FIG. 7 is a partially enlarged plan view of an external appearance and configuration of the light-transmitting solar cell module 1 of Example 2 as viewed from the rear, showing a further enlarged view of the portion B of FIG. 2. FIG. 8A is a cross-sectional view taken along line K1-K1 of FIG. 7. FIG. 8B is a cross-sectional view taken along line K2-K2 of FIG. 7.

In the light-transmitting solar cell module 1 of Example 2, the non-transparent member 31 made of a non-conductive material is provided on the third scribe lines 17 and the separation lines 19 excluding portions at which the third scribe lines 17 intersect the see-through lines 18. In other words, the non-transparent member 31 is provided only on the third scribe lines 17 and the separation lines 19 to cover the third scribe lines 17 and the separation lines 19 (specifically, the third scribe lines 17 and the separation lines 19 are filled with the non-transparent member).

Note that, in FIGS. 7, 8A, and 8B, the surface of the separation line 19 is not entirely covered, and the removal line 19a is formed by removing the non-transparent member 31 from a middle portion in the widthwise direction that extends along the separation line 19 and has a predetermined width (in this example, substantially the same width as that of the see-through line 18). The removal line 19a is provided, taking the creepage distance into consideration, in order to reduce or avoid the risk of electric discharge between the adjacent power generation regions. If the non-transparent member 31 is formed of a non-conductive material, the risk of electric discharge between the adjacent power generation regions is reduced or avoided, and it is not necessary to take the creepage distance into consideration. Therefore, the removal line 19a having the predetermined width is not necessarily required. In other words, the entire surface of the separation line 19 may also be covered by the non-transparent member 31.

With this configuration, the dark-colored (e.g., black etc.) non-transparent member 31 is provided on the third scribe lines 17 and the separation lines 19 excluding the see-through lines 18 (i.e., the third scribe line 17 and the separation line 19 excluding portions at which the third scribe lines 17 intersect the see-through lines 18), whereby light passing through the third scribe lines 17 and the separation lines 19 can be blocked on the rear side (the rear surface electrode layer 14 side) of the light-transmitting solar cell module 1. In other words, when the light-transmitting solar cell module 1 is viewed from the rear (the rear electrode layer 14 side), the see-through line 18 is the only line that is seen or noticed.

Next, a method for manufacturing the light-transmitting solar cell module 1 of Example 2 will be described.

After steps 1-8 have been finished (i.e., after the formation of the see-through line), the non-transparent member 31 is uniformly applied to the third scribe lines 17 and the separation lines 19 excluding portions at which the third scribe lines 17 intersect the see-through lines 18, of the rear surface electrode layer 14 of the light-transmitting solar cell module 1. This application step may be performed in a manner similar to that of Example 1 while the see-through lines 18 are masked. As a result, the third scribe lines 17 and the separation lines 19 are filled with the non-transparent member 31. Specifically, the non-transparent member 31 is made of a material that is viscous but can fill the lines without leaving a space.

Note that, when the removal line 19a is required in the separation line 19, step 7 may be performed again (in this time, the line width is changed to the width of the removal line 19a) after the application of the non-transparent material 31. As a result, the light-transmitting solar cell module 1 having the plan-view structure of FIG. 7 and the cross-sectional structure of FIGS. 8A and 8B can be fabricated.

According to the above manufacturing method, the dark-colored (e.g., black etc.) non-transparent member 31 is applied to the third scribe lines 17 and the separation lines 19 excluding portions at which the third scribe lines 17 intersect the see-through line 18, whereby light passing through the third scribe lines 17 can be blocked on the rear side (the rear surface electrode layer 14 side) of the light-transmitting solar cell module 1. Also, in Example 2, because the non-transparent member 31 is applied to (used to fill) only the third scribe lines 17 and the separation lines 19 excluding portions at which the third scribe lines 17 intersect the see-through line 18, the amount of the non-transparent member 31 can be reduced or minimized, and therefore, the manufacturing cost (specifically, the cost of the non-transparent member) can be proportionately reduced.

### <Example 3>

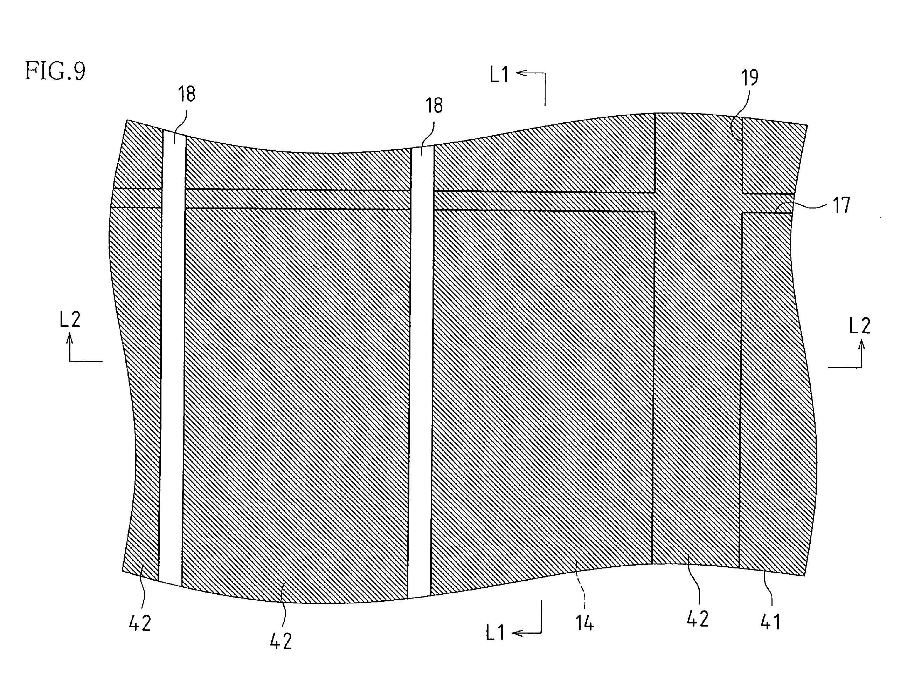

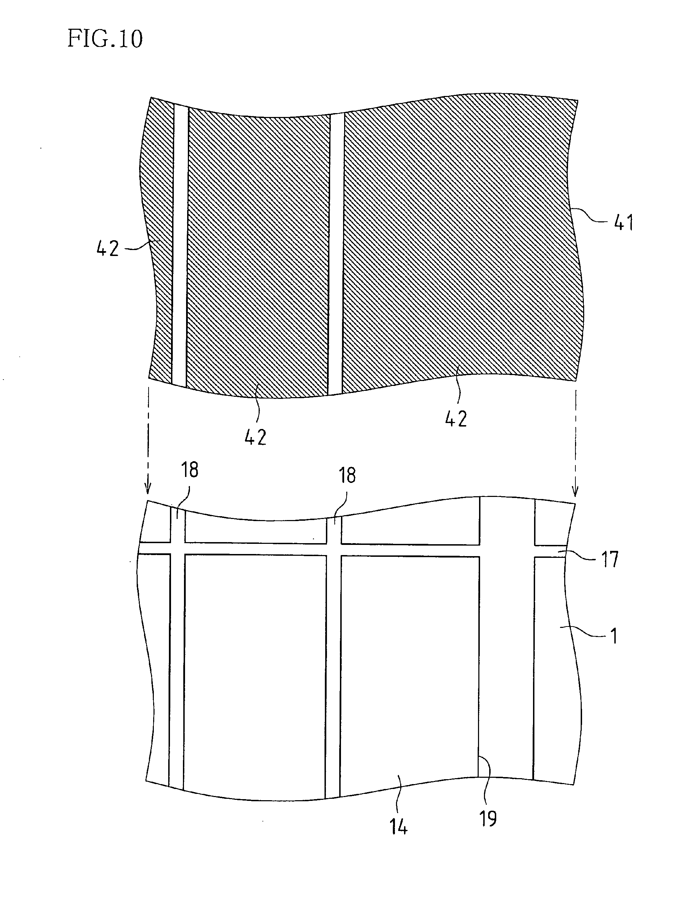

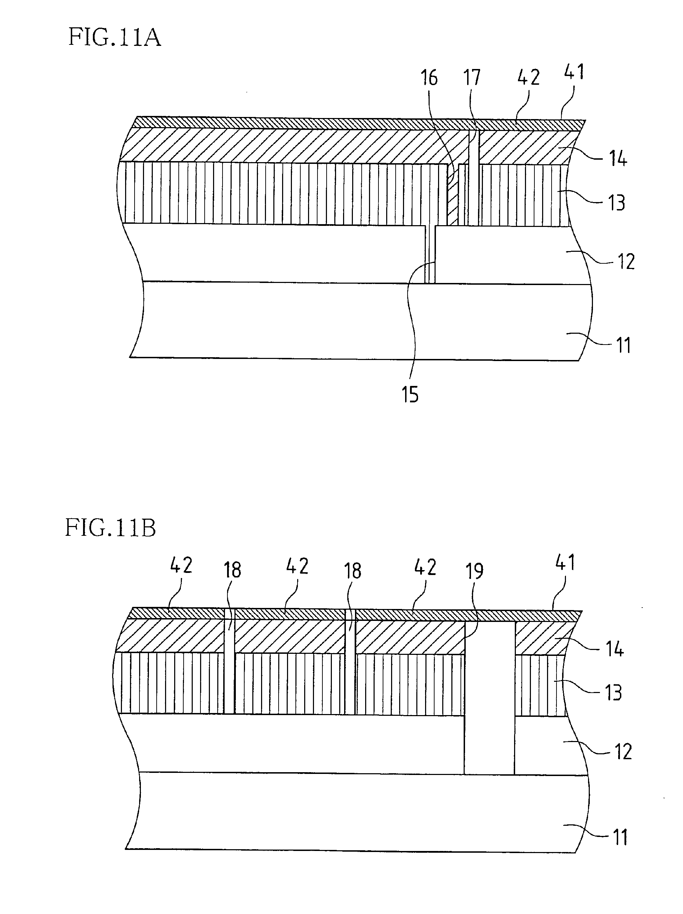

FIG. 9 is a partially enlarged plan view of an external appearance and configuration of the light-transmitting solar cell module 1 of Example 3 as viewed from the rear, showing a further enlarged view of the portion B of FIG. 2. FIG. 10 is a partially enlarged plan view showing the light-transmitting solar cell module 1, and an insulating film 41 before being attached to the rear surface electrode layer 14 of the light-transmitting solar cell module 1, separately. FIG. 11A is a cross-sectional view taken along line L1-L1 of FIG. 9. FIG. 11B is a cross-sectional view taken along line L2-L2 of FIG. 9.

In the light-transmitting solar cell module 1 of Example 3, the transparent member made of a non-conductive material is formed of a film having insulating properties (hereinafter referred to as an "insulating film") 41. The insulating film 41 is large enough to cover an entire surface closer to the rear surface electrode layer 14 of the light-transmitting solar cell module 1, and includes an insulating non-transparent material 42 that is provided on a portion of the insulating film 41 corresponding to the entire surface of the rear surface electrode layer 14 excluding the see-through lines 18 (i.e., an entire portion excluding the see-through lines 18 of a surface closer to the rear surface electrode layer 14 of the light-transmitting solar cell module 1). In Example 3, by attaching the insulating film 41 to the rear surface electrode layer 14 of the light-transmitting solar cell module 1, the rear surface electrode layer 14 excluding the see-through lines 18 is covered with the non-transparent material 42.

Here, the insulating film 41 and the non-transparent material 42 may be made of a resin material (coating), such as polyester-melamine, acrylic-melamine, etc., and are not particularly limited to these resin materials.

With this configuration, only by attaching the insulating film 41 including the non-transparent material 42 (e.g., a non-transparent ink made of the non-transparent material 42 is printed on the insulating film 41) to the rear surface electrode layer 14, light passing through the third scribe line 17 and the separation line 19 can be blocked on the rear side (the rear surface electrode layer 14 side) of the light-transmitting solar cell module 1. Also, the third scribe lines 17 and the separation lines 19 that need to be hidden can be easily covered by providing the non-transparent material 42 included in the insulating film 41 on the portion of the insulating film 41 corresponding to the entire surface of the rear surface electrode layer 14 excluding the see-through lines 18. Therefore, the non-transparent material 42 may be provided in the insulating film 41, taking into consideration only the positioning of the region where the non-transparent material 42 is provided with respect to the see-through lines 18, but not with respect to the third scribe lines 17 and the separation lines 19 that need to be hidden. Moreover, the non-transparent material 42 allows the entire surface of the rear surface electrode layer 14 excluding the see-through lines 18 to have a single uniform color (e.g., black etc.), resulting in an excellent ability to be designed and a muted appearance.

Next, a method for manufacturing the light-transmitting solar cell module 1 of Example 3 will be described.

In the manufacturing method of Example 3, after steps 1-8 have been finished (i.e., after the formation of the see-through line), the insulating film 41 including the insulating non-transparent material 42 on the portion corresponding to the entire surface of the rear surface electrode layer 14 of the light-transmitting solar cell module 1 excluding the see-through lines 18 may be applied via an adhesive member (not shown) to the rear surface electrode layer 14 of the light-transmitting solar cell module 1. In this case, the insulating film 41 may be positioned with respect to the rear surface electrode layer 14 using, for example, a reference that is used to form the third scribe line 17.

As a result, the light-transmitting solar cell module 1 having the plan-view structure of FIG. 9 and the cross-sectional structure of FIGS. 11A and 11B can be fabricated.

According to the manufacturing method, by attaching the insulating film 41 to the rear surface electrode layer 14, light passing through the third scribe line 17 can be blocked on the rear side (the rear surface electrode layer 14 side) of the light-transmitting solar cell module 1.

### <Example 4>

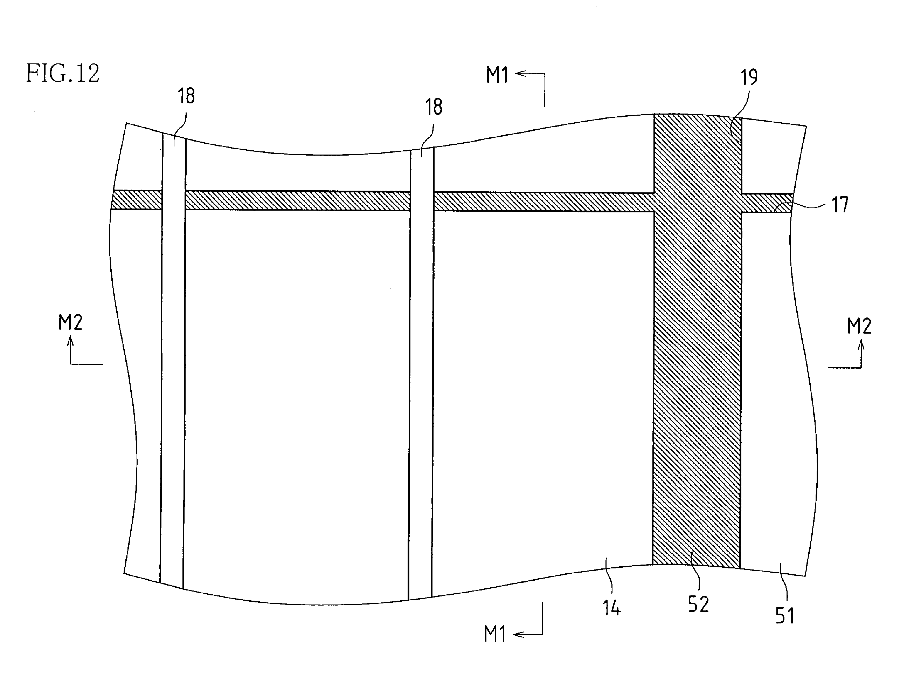

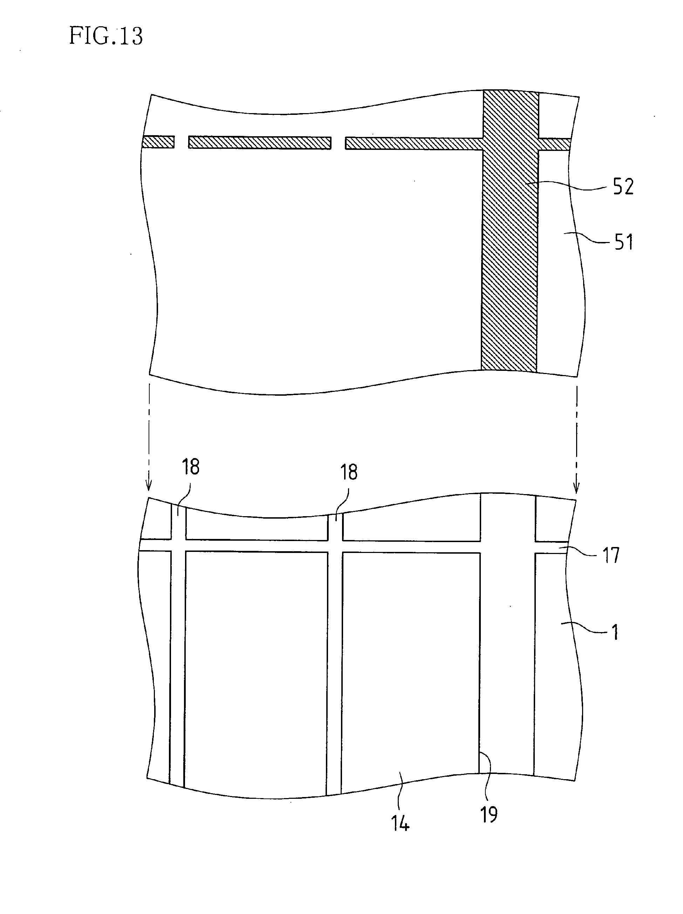

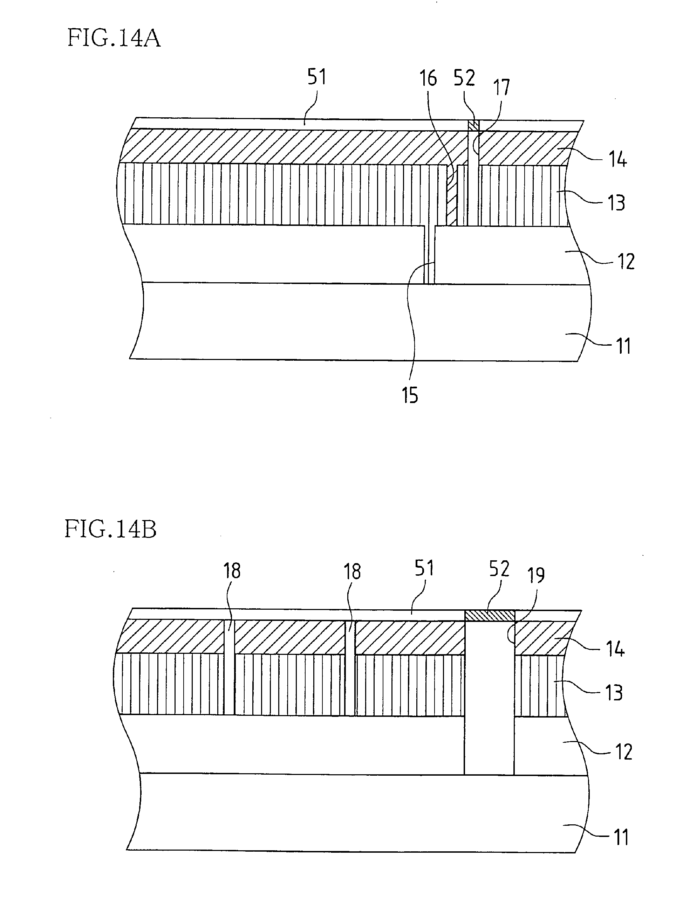

FIG. 12 is a partially enlarged plan view of an external appearance and configuration of the light-transmitting solar cell module 1 of Example 4 as viewed from the rear, showing a further enlarged view of the portion B of FIG. 2. FIG. 13 is a partially enlarged plan view showing the light-transmitting solar cell module 1, and an insulating film 41 before being attached to the rear surface electrode layer 14 of the light-transmitting solar cell module 1, separately. FIG. 14A is a cross-sectional view taken along line M1-M1 of FIG. 12. FIG. 14B is a cross-sectional view taken along line M2-M2 of FIG. 12.

In the light-transmitting solar cell module 1 of Example 4, the transparent member made of a non-conductive material is formed of a film having insulating properties (hereinafter referred to as "insulating film") 51. The insulating film 51 is large enough to cover an entire surface closer to the rear surface electrode layer 14 of the light-transmitting solar cell module 1, and includes an insulating non-transparent material 52 that is provided on portions of the insulating film 51 corresponding to the third scribe lines 17 and the separation lines 19 excluding the see-through lines 18 (i.e., portions of the insulating film 51 corresponding to the third scribe lines 17 and the separation lines 19 excluding portions at which the third scribe lines 17 intersect the see-through lines 18). In Example 4, by attaching the insulating film 51 to the rear surface electrode layer 14 of the light-transmitting solar cell module 1, the third scribe lines 17 and the separation lines 19 excluding the see-through lines 18 are covered with the non-transparent material 52.

Note that the insulating film 51 and the non-transparent material 52 may be made of the same materials as those of Example 3.

With this configuration, only by attaching the insulating film 51 including the non-transparent material 52 (e.g., a non-transparent ink made of the non-transparent material 52 is printed on the insulating film 51) to the rear surface electrode layer 14, light passing through the third scribe line 17 and the separation line 19 can be blocked on the rear side (the rear surface electrode layer 14 side) of the light-transmitting solar cell module 1. Also, the non-transparent material 52 is provided only at portions corresponding to the third scribe lines 17 and the separation lines 19 excluding the see-through lines 18, whereby the amount of the non-transparent member 52 can be reduced or minimized, and therefore, the manufacturing cost (specifically, the cost of the non-transparent member) can be proportionately reduced.

Next, a method for manufacturing the light-transmitting solar cell module 1 of Example 4 will be described.

In the manufacturing method of Example 4, after steps 1-8 have been finished (i.e., after the formation of the see-through line), the insulating film 51 including the insulating non-transparent material 52 at the portions corresponding to the third scribe lines 17 and the separation lines 19 excluding the see-through lines 18 may be applied via an adhesive member (not shown) to the rear surface electrode layer 14 of the light-transmitting solar cell module 1. In this case, the insulating film 51 may be positioned with respect to the rear surface electrode layer 14 using, for example, a reference that is used to form the third scribe line 17.

As a result, the light-transmitting solar cell module 1 having the plan-view structure of FIG. 12 and the cross-sectional structure of FIGS. 14A and 14B can be fabricated.

According to the manufacturing method, by attaching the insulating film 51 to the rear surface electrode layer 14, the third scribe lines 17 and the separation lines 19 excluding the see-through lines 18 can be covered with the non-transparent material 52. As a result, light passing through the third scribe line 17 and the separation line 19 can be reliably blocked on the rear side (the rear surface electrode layer 14 side) of the light-transmitting solar cell module 1. Also, in Example 4, the non-transparent material 52 is provided only at film portions corresponding to the third scribe lines 17 and the separation lines 19 excluding the see-through lines 18, whereby the amount of the non-transparent member 52 can be reduced or minimized, and therefore, the manufacturing cost (specifically, the cost of the non-transparent member) can be proportionately reduced.

Note that, in Examples 1 and 2, the non-transparent member 31 is basically formed of a single material by performing the application step once (i.e., a monolayer structure). Alternatively, the non-transparent member 31 may be formed of a plurality of materials having different colors (e.g., two colors) by performing the application step twice (i.e., a double-layer structure) on the rear surface electrode layer 14 of the light-transmitting solar cell module 1. Specifically, the first layer is made of a black material that can reliably block light, and the second layer is made of a material having the same type of color (e.g., beige) as that of the color of the vehicle's interior, whereby the light-transmitting solar cell module 1 can be fabricated in which light transmission is reliably blocked and that can match the color of the vehicle's interior, and has excellent texture and ability to be designed.

Similarly, in Examples 3 and 4, the non-transparent member 42, 52 is basically formed of a single material by performing the application step once on the insulating film 41, 51 (i.e., a monolayer structure). Alternatively, the non-transparent member 42, 52 may be formed of a plurality of materials having different colors (e.g., two colors) by performing the application step twice on the insulating film 41, 51 (i.e., a double-layer structure). Specifically, the first layer is made of a black material that can reliably block light, and the second layer is made of a material having the same type of color (e.g., beige) as that of the color of the vehicle's interior, whereby the light-transmitting solar cell module 1 can be fabricated in which light transmission is reliably blocked and that can match the color of the vehicle's interior, and has excellent texture and ability to be designed.

In all of Examples 1-4, the non-transparent member 31 is provided for the purpose of blocking light passing through the third scribe line 17 and the separation line 19 and thereby providing good appearance, when the light-transmitting solar cell module 1 is seen from the rear (the rear surface electrode layer 14 side). Specifically, when the light-transmitting solar cell module 1 is seen from the rear (the rear surface electrode layer 14 side), the light-transmitting solar cell module 1 has substantially a single uniform color, excluding the see-through lines 18. The rear surface electrode layer 14 does not substantially affect the efficiency of power generation unlike the light reception surface. Therefore, the non-transparent member 31 can be not only used to block light passing through the portion excluding the see-through lines 18, but also arbitrarily designed so that the light-transmitting solar cell module matches the surrounding design of a place where the light-transmitting solar cell module is installed.

Specific example methods for manufacturing the light-transmitting solar cell module in which the non-transparent member 31 is used to provide an arbitrary design on the rear surface electrode layer 14 will be described hereinafter.

### <Example 5>

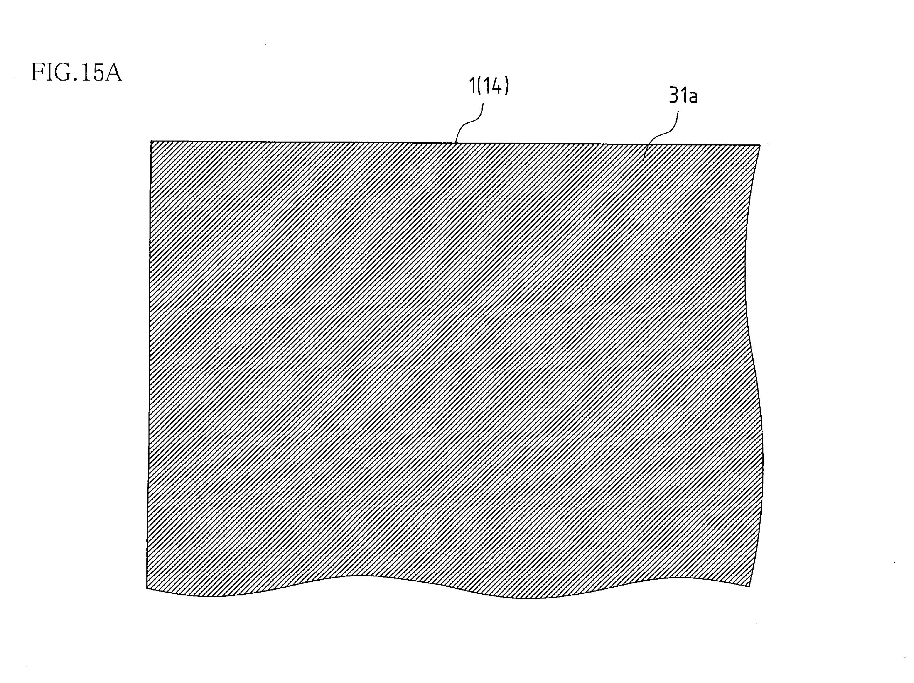

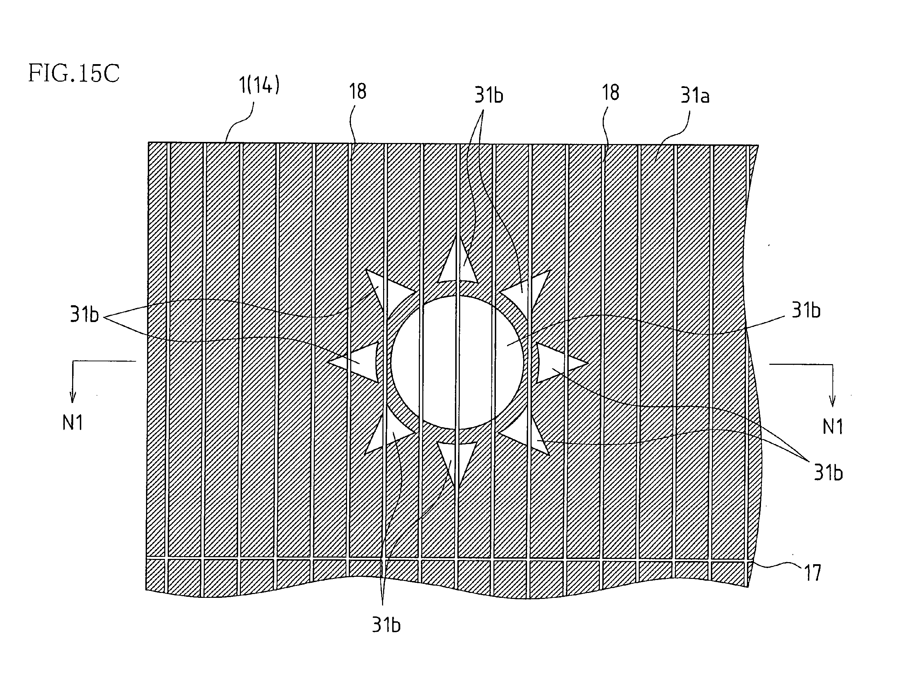

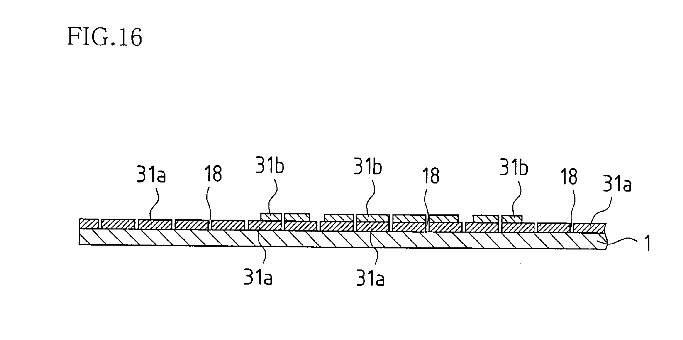

A manufacturing method of Example 5 is a method for manufacturing the light-transmitting solar cell module 1 using the manufacturing method of Example 1. FIGS. 15A-15C are partially enlarged plan views of the light-transmitting solar cell module 1 as viewed from the rear, showing steps of the manufacturing method of Example 5. FIG. 16 is a cross-sectional view taken along line N1-N1 of FIG. 15C.

Similar to the manufacturing method of Example 1, after steps 1-7 have been finished (i.e., before the formation of the see-through line), a black or dark-colored non-transparent member 31a is formed on an entire surface of the rear surface electrode layer 14 of the light-transmitting solar cell module 1 by a patterning technique, such as screen printing, photolithography, etc. (see FIG. 15A).

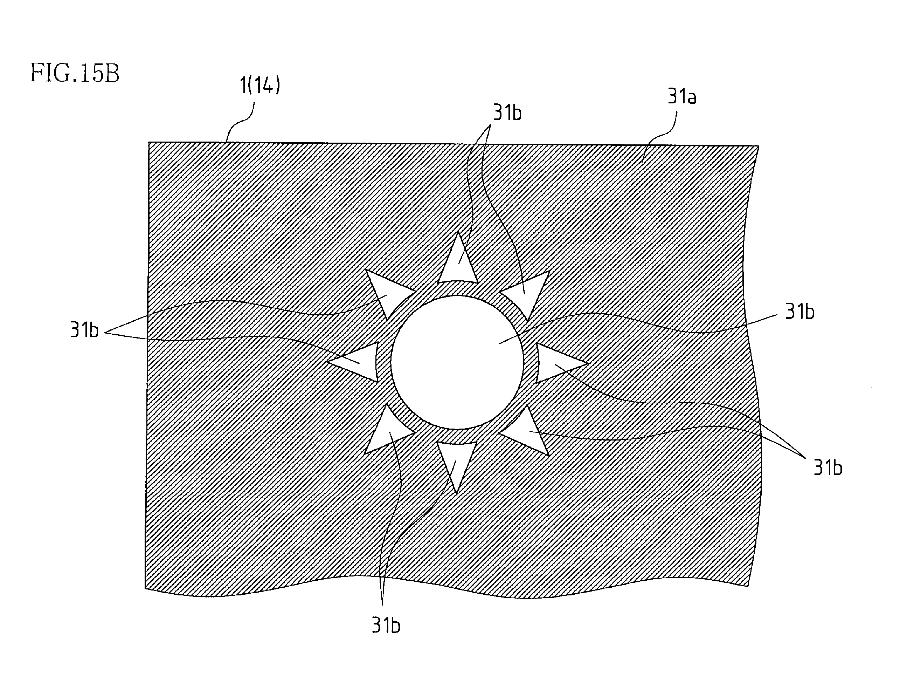

Next, a non-transparent member 31b having a color is selected based on the design of a pattern to be formed. The non-transparent member 31b is used to perform patterning, such as screen printing, photolithography, etc., a required number of times, on the previously formed non-transparent member 31a, thereby forming an arbitrary design of the non-transparent member 31b (see FIG. 15B). As a result, the non-transparent members 31a and 31b can be used to form an arbitrary pattern (design) on the rear surface electrode layer 14. In the example of FIG. 15B, the non-transparent member 31b is used to form a yellow pattern designed to represent the sun.

Finally, step 8 is performed on the light-transmitting solar cell module 1 in which the non-transparent member 31 (31a, 31b) has been formed, whereby the non-transparent member 31 (31a, 31b), the rear surface electrode layer 14, and the photoelectric conversion layer 13 are removed to form the see-through lines 18 that reach the front surface electrode layer 12 (see FIGS. 15C and 16).

### <Example 6>

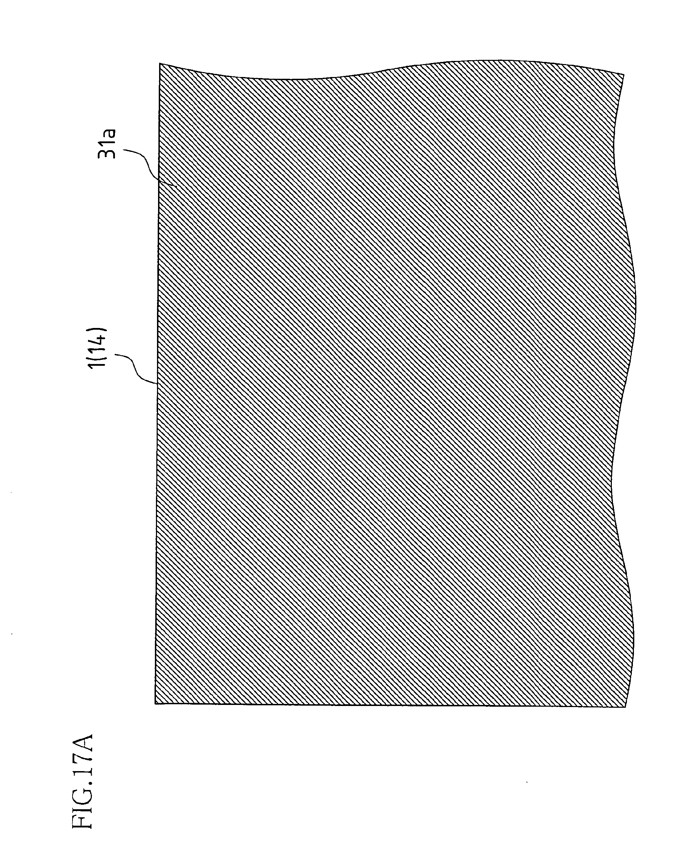

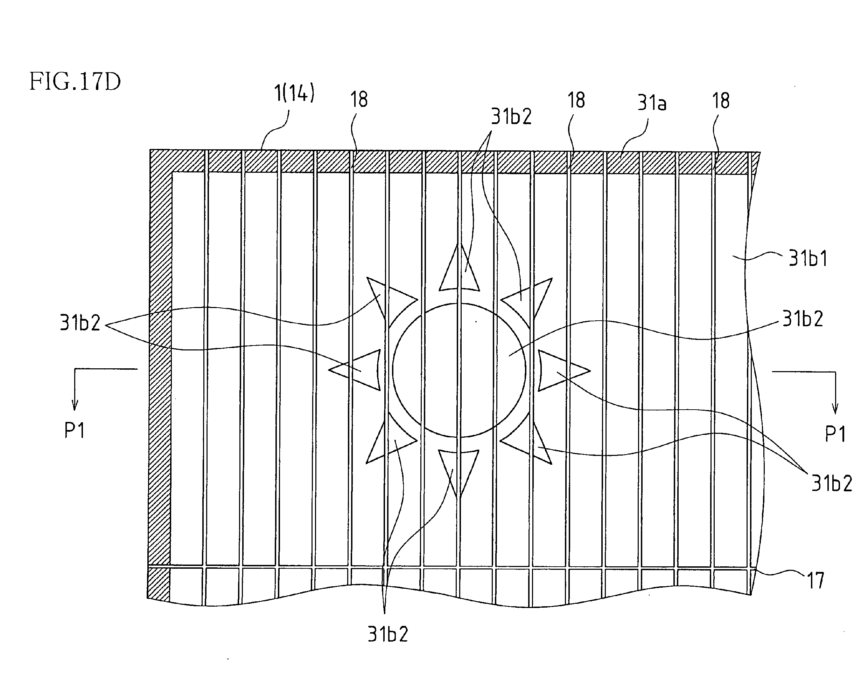

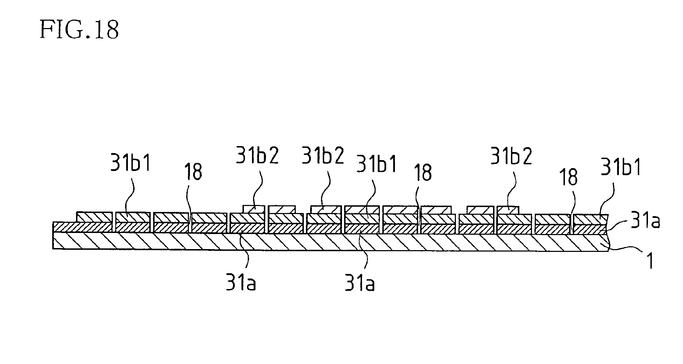

A manufacturing method of Example 6 is a method for manufacturing the light-transmitting solar cell module 1 using the manufacturing method of Example 1. FIGS. 17A-17D are partially enlarged plan views of the light-transmitting solar cell module 1 as viewed from the rear, showing steps of the manufacturing method of Example 6. FIG. 18 is a cross-sectional view taken along line P1-P1 of FIG. 17D. Example 6 is a specific example where a full-color design is formed in Example 5.

Similar to the manufacturing method of Example 1, after steps 1-7 have been finished (i.e., before the formation of the see-through line), a black or dark-colored non-transparent member 31a is formed on an entire surface of the rear surface electrode layer 14 of the light-transmitting solar cell module 1 by a patterning technique, such as screen printing, photolithography, etc. (see FIG. 17A).

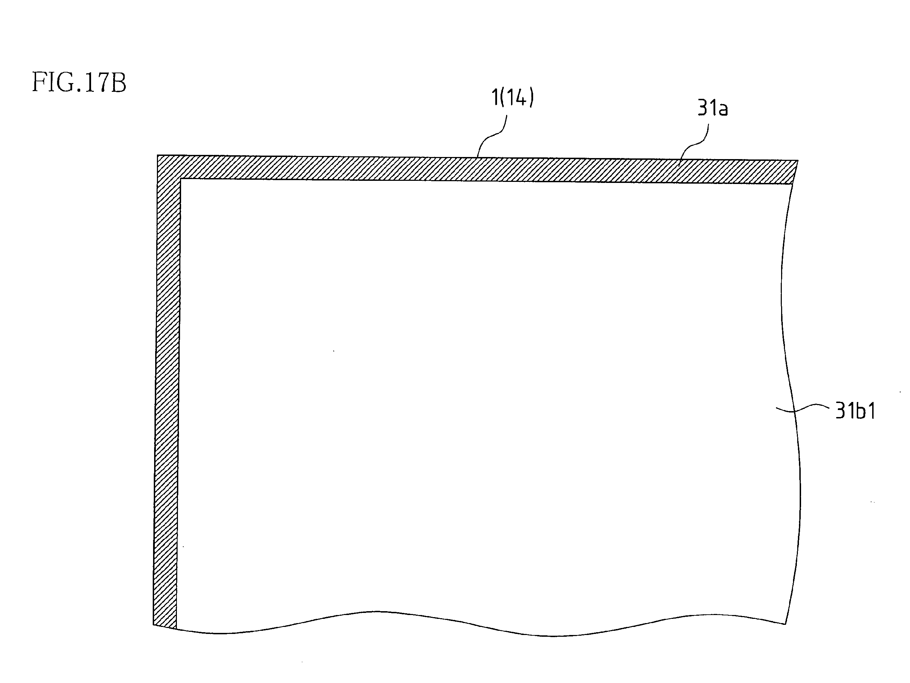

Next, when a full-color design, such as a photograph etc., is formed, a white non-transparent member 31b1 is formed on the black or dark-colored non-transparent member 31a (see FIG. 17B).

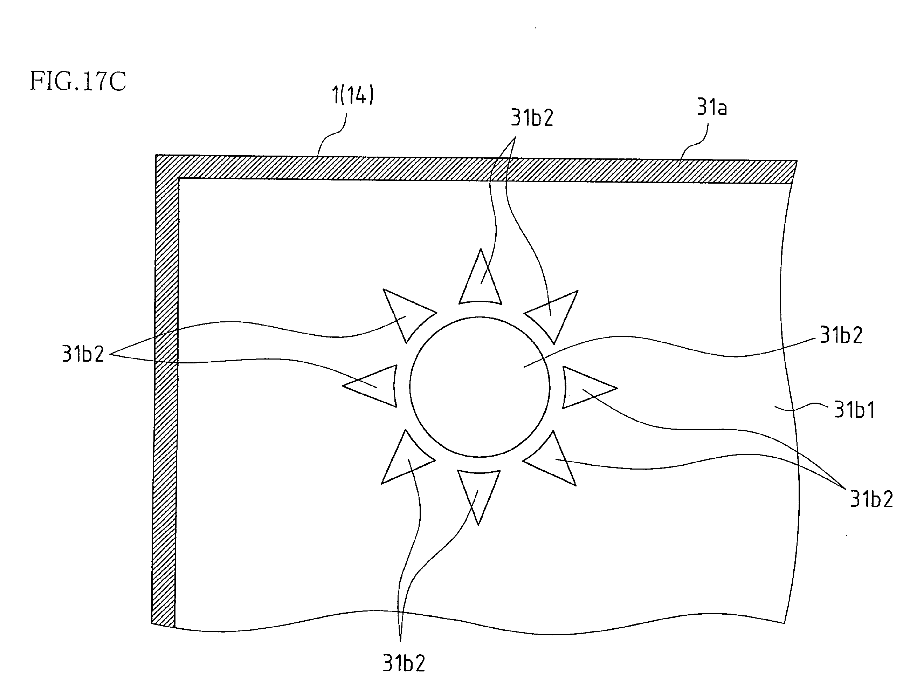

Thereafter, a non-transparent member 31b2 having yellow, magenta, cyan, and black colors etc. is used to perform patterning, such as screen printing, photolithography, etc., a plurality of times, based on the principle of so-called subtractive color mixing. As a result, the non-transparent members 31a and 31b1 and 31b2 can be used to form an arbitrary pattern (full-color design) on the rear surface electrode layer 14 (FIG. 17C). In the example of FIG. 17C, a color design is formed that has a red circle (the sun) at the center and yellow triangular marks (the sun's rays) around the circle. Note that, in the case of subtractive color mixing, a black pattern may be removed by forming the pattern on the underlying white non-transparent member 31a.

Finally, step 8 is performed on the light-transmitting solar cell module 1 in which the non-transparent members 31a and 31b (31b1, 31b2) have been formed, whereby the non-transparent member 31, the rear surface electrode layer 14, and the photoelectric conversion layer 13 are removed to form the see-through lines 18 that reach the front surface electrode layer 12 (see FIGS. 17D and 18).

### <Example 7>

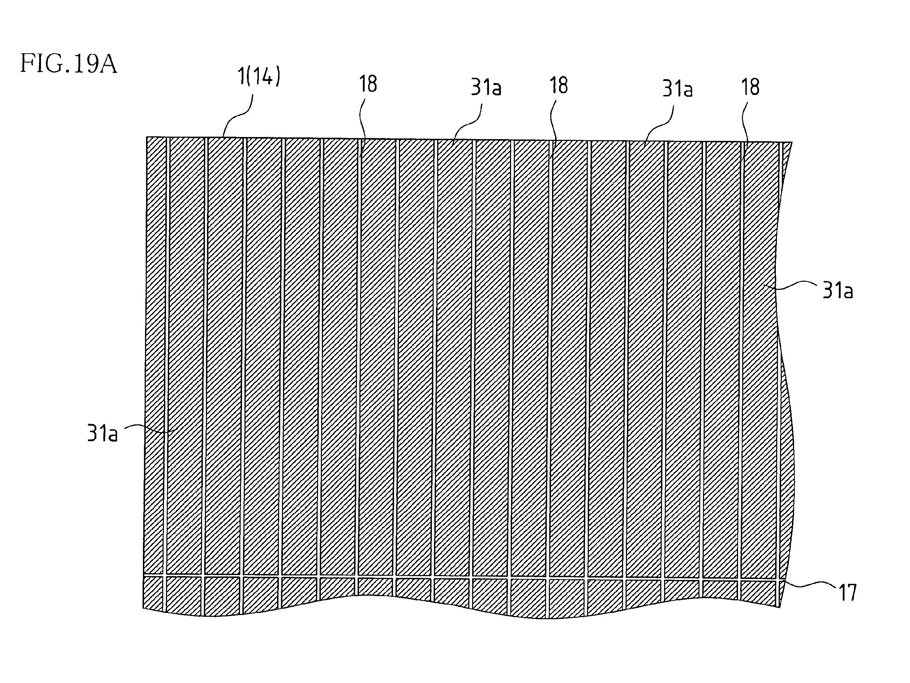

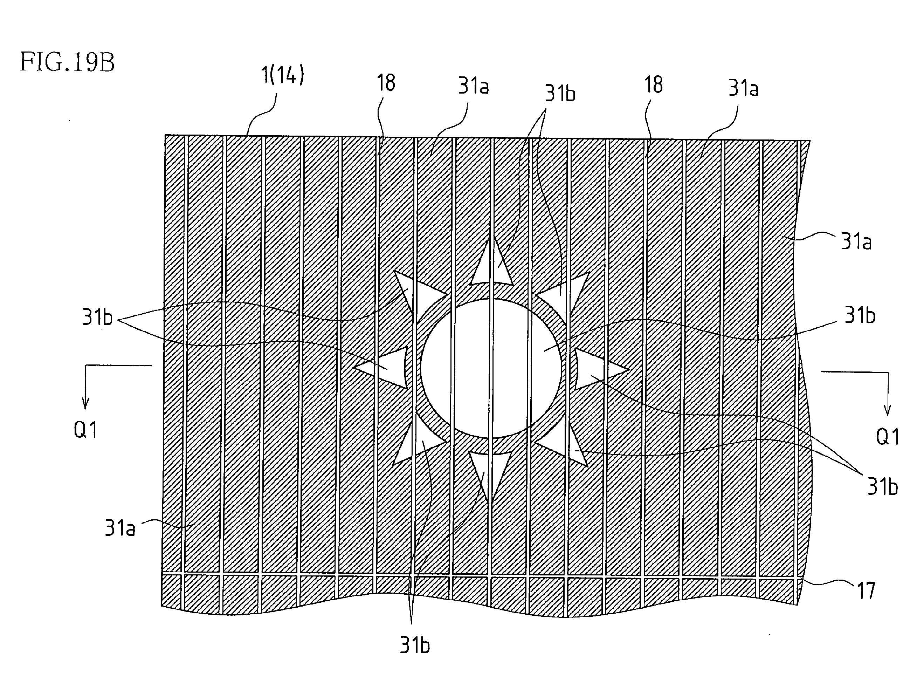

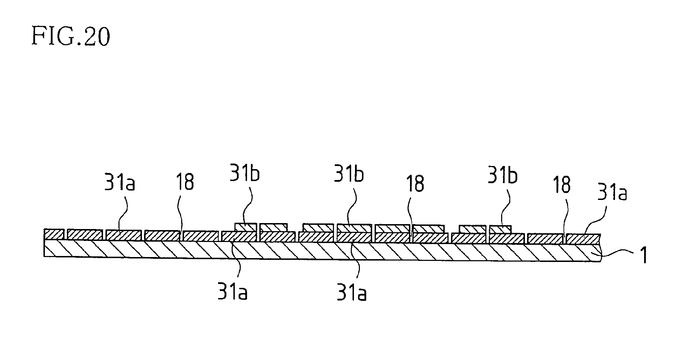

A manufacturing method of Example 7 is a method for manufacturing the light-transmitting solar cell module 1 using the manufacturing method of Example 2. FIGS. 19A and 19B are partially enlarged plan views of the light-transmitting solar cell module 1 as viewed from the rear, showing steps of the manufacturing method of Example 7. FIG. 20 is a cross-sectional view taken along line Q1-Q1 of FIG. 19B.

After steps 1-8 have been finished (i.e., after the formation of the see-through line), a black or dark-colored non-transparent member 31a is formed on the rear surface electrode layer 14 of the light-transmitting solar cell module 1 in a region where the rear surface electrode layer 14 is provided and in a region where the rear surface electrode layer 14 is not provided but light is desired to be blocked, excluding the see-through lines 18, by a patterning technique, such as screen printing, photolithography, etc. (see FIG. 19A). In FIG. 19A, for the sake of simplicity, the non-transparent member 31a is formed in the regions excluding the see-through lines 18.

Next, the non-transparent member 31b having a color required corresponding to the design of a pattern to be formed is selected. The selected non-transparent member 31b is used to form an arbitrary design on the previously formed non-transparent member 31a in the region where the rear surface electrode layer 14 is provided and in the region where the rear surface electrode layer 14 is not provided but light is desired to be blocked, by performing application a required number of times using a patterning technique, such as screen printing, photography, etc. (see FIG. 19B and 20). As a result, the non-transparent members 31a and 31b can be used to form an arbitrary pattern (design) on the rear surface electrode layer 14. In the example of FIG. 19B, the non-transparent member 31b having a yellow color is used to form a design representing the sun.

### <Example 8>

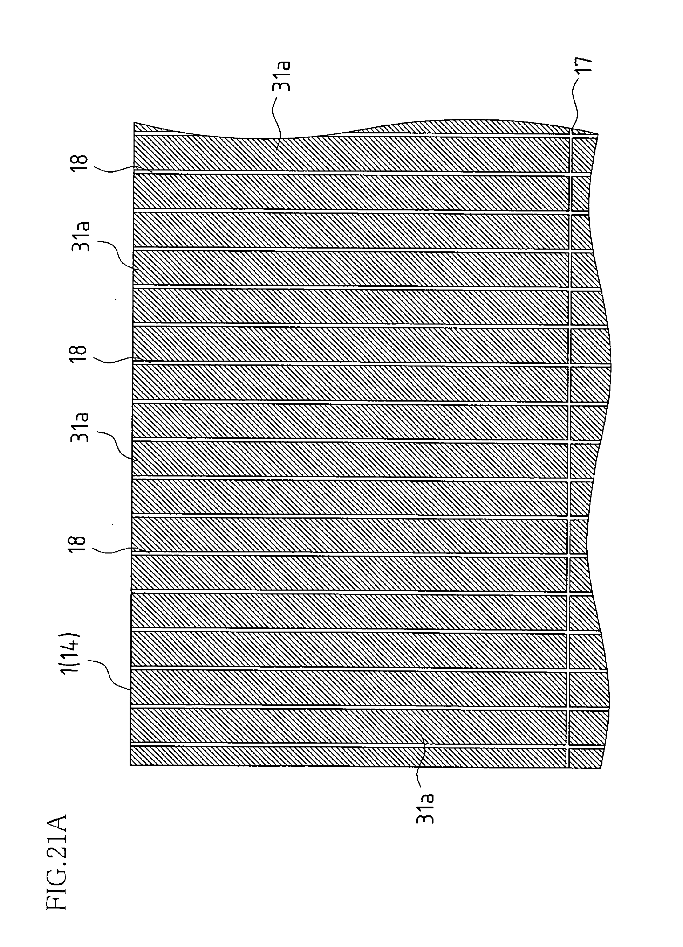

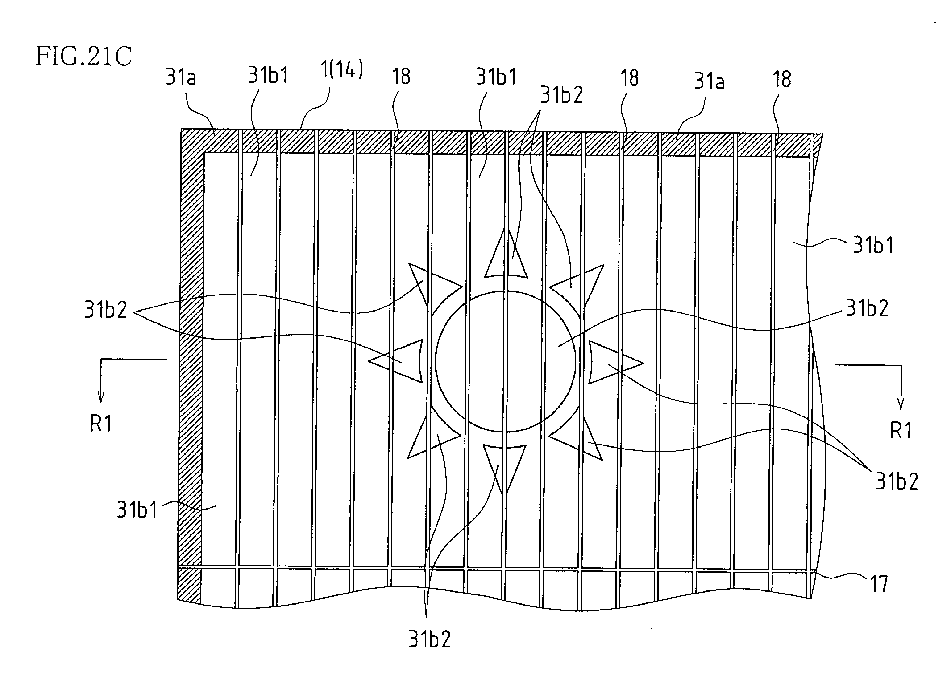

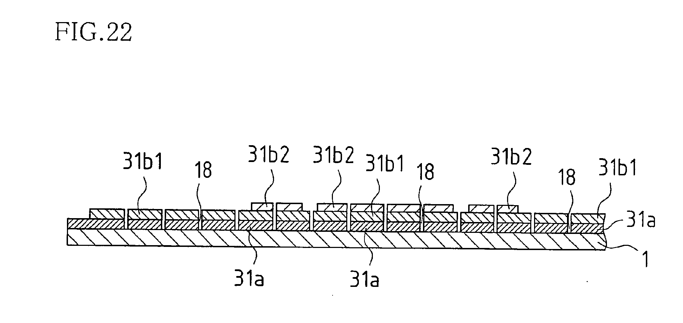

A manufacturing method of Example 8 is a method for manufacturing the light-transmitting solar cell module 1 using the manufacturing method of Example 2. FIGS. 21A-21C are partially enlarged plan views of the light-transmitting solar cell module 1 as viewed from the rear, showing steps of the manufacturing method of Example 8. FIG. 22 is a cross-sectional view taken along line R1-R1 of FIG. 21C.

After steps 1-8 have been finished (i.e., after the formation of the see-through line), a black or dark-colored non-transparent member 31a is formed on the rear surface electrode layer 14 of the light-transmitting solar cell module 1 in a region where the rear surface electrode layer 14 is provided and in a region where the rear surface electrode layer 14 is not provided but light is desired to be blocked, excluding the see-through lines 18, by a patterning technique, such as screen printing, photolithography, etc. (see FIG. 21A). In FIG. 21A, for the sake of simplicity, the non-transparent member 31a is formed in the regions excluding the see-through lines 18.

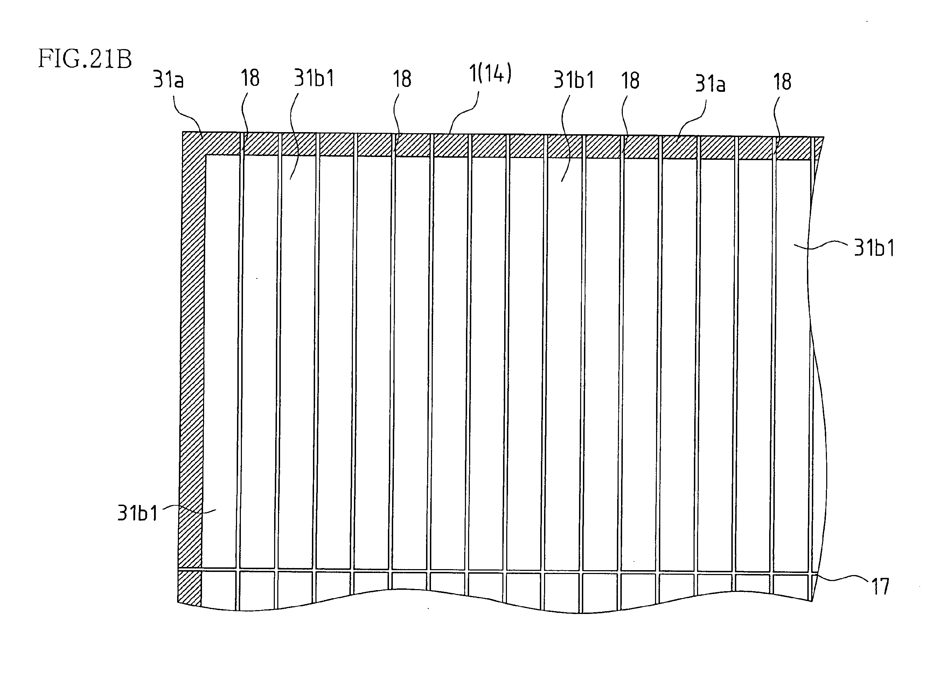

Next, when a full-color design, such as a photograph etc., is formed, a white non-transparent member 31b1 is formed on the previously formed black or dark-colored non-transparent member 31a in the regions excluding the see-through lines 18 (see FIG. 21B).

Thereafter, a non-transparent member 31b2 having yellow, magenta, cyan, and black colors etc. is used to perform patterning, such as screen printing, photolithography, etc., a plurality of times, based on the principle of so-called subtractive color mixing. As a result, an arbitrary pattern (full-color design) can be formed on the white non-transparent member 31b1 in the regions excluding the see-through lines 18. In the example of FIG. 21C, a color design is formed that has a red circle (the sun) at the center and yellow triangular marks (the sun's rays) around the circle. Note that, in the case of subtractive color mixing, a black pattern may be removed by forming the pattern on the underlying white non-transparent member 31a.

Note that, in this embodiment, the see-through line 18 is formed by removing the rear surface electrode layer 14 and the photoelectric conversion layer 13 to reach the front surface electrode layer 12. Alternatively, the see-through line 18 may be formed by removing the rear surface electrode layer 14, the photoelectric conversion layer 13, and the front surface electrode layer 12 to reach the translucent insulating substrate 11.

Moreover, in this embodiment, the example light-transmitting solar cell module 1 has a structure in which the power generation portion 1A is separated into the six power generation regions 1A1-1A6 by the separation lines 19. Alternatively, some small-size light-transmitting solar cell modules do not have a separation line. The present invention is also applicable to the light-transmitting solar cell module without a separation line. In the case, only the third scribe line is covered by the non-transparent member.

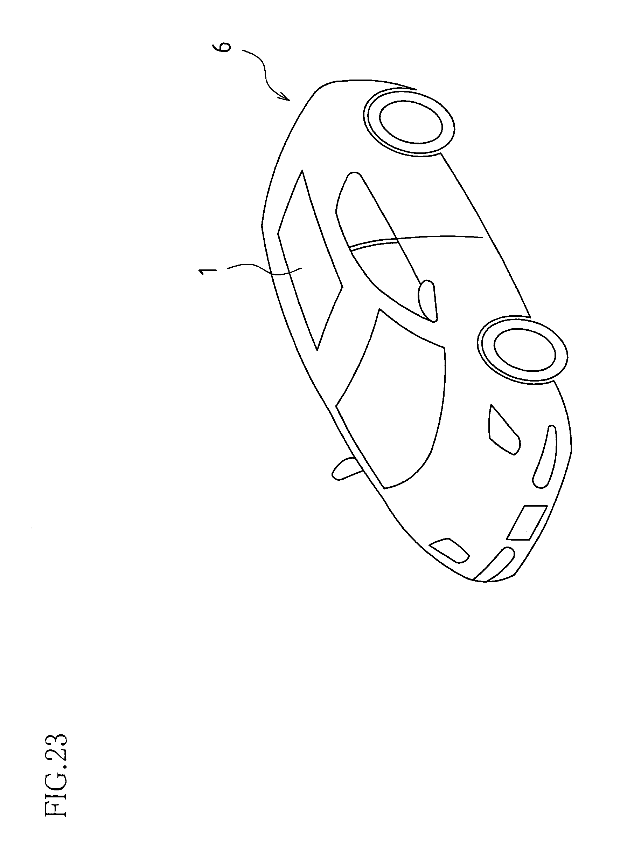

FIG. 23 is a perspective view showing a general configuration of a vehicle including the light-transmitting solar cell module of this embodiment as a sunroof.

As shown in FIG. 23, the light-transmitting solar cell module of this embodiment as described in any of Examples 1-8 is mounted as a sunroof on a roof of a vehicle body while also serving as an auxiliary power source for the vehicle (a mobile object as used herein). The vehicle including the light-transmitting solar cell module of this embodiment as a sunroof has an excellent ability to be designed because the scribes lines and separation lines of the light-transmitting solar cell module are not seen or noticed from the vehicle's interior.

The present invention can be embodied and practiced in other different forms without departing from the spirit and essential characteristics thereof. Therefore, the above-described embodiments are considered in all respects as illustrative and not restrictive. The scope of the invention is indicated by the appended claims rather than by the foregoing description. All variations and modifications falling within the equivalency range of the appended claims are intended to be embraced therein.

This application claims priority on Patent Application No. 2010-011932 filed in Japan on January 22, 2010 and Patent Application No. 2010-225689 filed in Japan on October 5, 2010, which are hereby incorporated by reference in their entirety.

### Industrial Applicability

The present invention is applicable to light-transmitting solar cell modules including a see-through line that allows light to pass through from the front surface to the rear surface of a power generation portion, methods for manufacturing the light-transmitting solar cell module, and mobile objects including the light-transmitting solar cell module.

### Description of Reference Characters

- 1: LIGHT-TRANSMITTING SOLAR CELL MODULE
- 1A: POWER GENERATION PORTION
- 1A1-1A6: POWER GENERATION REGION
- 11: TRANSLUCENT INSULATING SUBSTRATE
- 12: TRANSPARENT FRONT SURFACE ELECTRODE LAYER
- 13: PHOTOELECTRIC CONVERSION LAYER
- 14: REAR SURFACE ELECTRODE LAYER
- 15: SEPARATION LINE (FIRST SCRIBE LINE)
- 16: CONTACT LINE (SECOND SCRIBE LINE)
- 17: THIRD SCRIBE LINE
- 18: SEE-THROUGH LINE
- 19: SEPARATION LINE
- 19a: REMOVAL LINE
- 21: SOLAR CELL
- 31, 31a, 31b, 31b1, 31b2: NON-TRANSPARENT MEMBER
- 41, 51: FILM (INSULATING FILM)
- 42, 52: NON-TRANSPARENT MATERIAL
- 6: VEHICLE (MOBILE OBJECT)

## Claims

1. A light-transmitting solar cell module including a light-transmitting portion that allows light to pass through from a front surface to a rear surface of a power generation portion, wherein
a portion of the light-transmitting portion is covered by an insulating non-transparent member.

2. The light-transmitting solar cell module according to claim 1, wherein
the power generation portion includes a plurality of solar cells each including a front surface electrode layer, a photoelectric conversion layer, and a rear surface electrode layer successively stacked on a translucent insulating substrate, and
the light-transmitting portion includes a plurality of linear opening grooves formed by removing the rear surface electrode layer and the photoelectric conversion layer, and the non-transparent member is provided, corresponding to a portion of the opening grooves.

3. The light-transmitting solar cell module according to claim 2, wherein
the light-transmitting portion includes a scribe line separating the rear surface electrode layer into portions in order to connect the plurality of solar cells together in series, and a see-through line that allows light to pass through, and
the non-transparent member is provided on an entire surface of the rear surface electrode layer excluding the see-through line.

4. The light-transmitting solar cell module according to claim 2, wherein
the light-transmitting portion includes a scribe line separating the rear surface electrode layer into portions in order to connect the plurality of solar cells together in series, and a see-through line that allows light to pass through, and
the non-transparent member is provided on the scribe line excluding the see-through line.

5. The light-transmitting solar cell module according to claim 2, wherein
the light-transmitting portion includes a scribe line separating the rear surface electrode layer into portions in order to connect the plurality of solar cells together in series, and a see-through line that allows light to pass through,
the non-transparent member is an insulating film including an insulating non-transparent material provided at a portion thereof corresponding to an entire surface of the rear surface electrode layer excluding the see-through line, and
the film is attached to the rear surface electrode layer.

6. The light-transmitting solar cell module according to claim 2, wherein
the light-transmitting portion includes a scribe line separating the rear surface electrode layer into portions in order to connect the plurality of solar cells together in series, and a see-through line that allows light to pass through,
the non-transparent member is an insulating film including an insulating non-transparent material provided at a portion thereof corresponding to the scribe line excluding the see-through line, and
the film is attached to the rear surface electrode layer.

7. The light-transmitting solar cell module according to any one of claims 1-4, wherein
the light-transmitting solar cell module includes a separation line separating the power generation portion into a plurality of power generation regions, and
the non-transparent member is also provided on the separation line.

8. The light-transmitting solar cell module according to claim 5 or 6, wherein
the light-transmitting solar cell module includes a separation line separating the power generation portion into a plurality of power generation regions, and
in the film, the non-transparent material is also provided at a portion thereof corresponding to the separation line.

9. The light-transmitting solar cell module according to claim 7, wherein
the non-transparent member provided on the separation line is removed along the separation line by a predetermined width.

10. The light-transmitting solar cell module according to any one of claims 1-4, 7, and 9, wherein
the non-transparent member has a multilayer structure including a plurality of members having different colors.

11. The light-transmitting solar cell module according to claim 5 or 6, wherein
the non-transparent material has a multilayer structure including a plurality of materials having different colors.

12. A method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of:
forming the plurality of solar cells on the translucent insulating substrate;
applying a non-transparent member to an entire surface of the rear surface electrode layer after the formation of the solar cells; and
forming the see-through line by removing the non-transparent member, the rear surface electrode layer, and the photoelectric conversion layer after the application of the non-transparent member.

13. The method according to claim 12, wherein
the applying step includes applying another non-transparent member to any region on the non-transparent member applied to the entire surface of the rear surface electrode layer.

14. A method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of:
forming the plurality of solar cells on the translucent insulating substrate;
forming the see-through line by removing the rear surface electrode layer and the photoelectric conversion layer after the formation of the solar cells; and
applying a non-transparent member to a scribe line that is formed during the formation of the plurality of solar cells to separate the rear surface electrode layer into portions in order to connect the plurality of solar cells together in series.

15. A method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of:
forming the plurality of solar cells on the translucent insulating substrate;
forming the see-through line by removing the rear surface electrode layer and the photoelectric conversion layer after the formation of the solar cells;
first applying a non-transparent member to a region where the rear surface electrode layer is provided and/or to a region where the rear surface electrode layer is not provided but light is desired to be blocked; and
second applying another non-transparent member to any region on the applied non-transparent member.

16. A method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of:
forming the plurality of solar cells on the translucent insulating substrate;
forming the see-through line by removing the rear surface electrode layer and the photoelectric conversion layer after the formation of the solar cells; and
attaching to the rear surface electrode layer an insulating film including an insulating non-transparent material at a portion thereof corresponding to an entire surface of the rear surface electrode layer excluding the see-through line.

17. A method for manufacturing a light-transmitting solar cell module including a power generation portion including a plurality of solar cells each including a front surface electrode layer, a photoelectric conversion layer, and a rear surface electrode layer successively stacked on a translucent insulating substrate, and a see-through line that is formed in the power generation portion and allows light to pass through, the method comprising the steps of:
forming the plurality of solar cells on the translucent insulating substrate;
forming the see-through line by removing the rear surface electrode layer and the photoelectric conversion layer after the formation of the solar cells; and
attaching to the rear surface electrode layer an insulating film including an insulating non-transparent material at a portion thereof corresponding to the scribe line excluding the see-through line.

18. The method according to any one of claims 12-14, wherein
the light-transmitting solar cell module includes a separation line separating the power generation portion into a plurality of power generation regions, and
in the applying step, the non-transparent member is also applied to the-separation line.

19. The method according to claim 16 or 17, wherein
the light-transmitting solar cell module includes a separation line separating the power generation portion into a plurality of power generation regions, and
in the film, the non-transparent material is also provided at a portion thereof corresponding to the separation line.

20. A mobile object including as a sunroof the light-transmitting solar cell module according to any one of claims 1-11.
